(19) **Europäisches Patentamt**
**European Patent Office**
**Office européen des brevets**

(11) **EP 3 091 337 A1**

(12) **EUROPEAN PATENT APPLICATION**

(43) Date of publication:
**09.11.2016 Bulletin 2016/45**

(21) Application number: **16165060.1**

(22) Date of filing: **13.04.2016**

(51) Int Cl.:
*G01C 21/36* (2006.01)　　*G06F 3/16* (2006.01)
*G10L 25/48* (2013.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **23.04.2015 JP 2015088717**

(71) Applicant: **FUJITSU LIMITED**
**Kawasaki-shi,**
**Kanagawa 211-8588 (JP)**

(72) Inventors:
• **Shioda, Chisato**
**Kanagawa, 211-8588 (JP)**
• **Togawa, Taro**
**Kanagawa, 211-8588 (JP)**
• **Otani, Takeshi**
**Kanagawa, 211-8588 (JP)**

(74) Representative: **Hoffmann Eitle**
**Patent- und Rechtsanwälte PartmbB**
**Arabellastraße 30**
**81925 München (DE)**

(54) **CONTENT REPRODUCTION DEVICE, CONTENT REPRODUCTION PROGRAM, AND CONTENT REPRODUCTION METHOD**

(57)　A content reproduction device including: a sound acquisition unit that acquires a first sound around an user; an reaction detection unit that detects an reaction of the user; a within-period reaction determination unit that determines that there is a within-period reaction in a case in which the reaction is detected within a predetermined period from an acquisition time point of the first sound based on a temporal relation between the first sound and the detected reaction; and a reproduction control unit that performs control such that reproduction of content is restricted or performs control such that a part of the content reproduced within a period in which the detection of the reaction within the predetermined period continues is reproduced again after the period in the case in which the within-period reaction determination unit determines that there is the within-period reaction.

EP 3 091 337 A1

## Description

FIELD

The embodiments discussed herein are related to a content reproduction device, a content reproduction program, and a content reproduction method. Here, "reproduction" includes "play back" of audio/visual contents.

BACKGROUND

In recent years, as sound reading-aloud functions and wearable headsets have spread, forms in which the wearable headsets are regularly worn and sound information is reproduced at any time are considered to spread in future. For example, there is a form in which a title is automatically read aloud when an electronic mail arrives.

In the technology, when a sound is read aloud in the middle of conversation of a user, it is difficult for the user to give utterances in the conversation and it is also difficult for the user to hear utterance of a partner of the conversation.

Accordingly, as a technology of related art applied to resolve this problem, there is a technology for controlling an output of information based on a conversation situation in a vehicle and not interfering with conversation in the vehicle by an information supply device. According to this technology, a conversation situation is detected based on a sound in a vehicle and an information sound output from an information sound output unit is controlled based on the detected conversation situation in the vehicle. Specifically, in a case in which a conversation state in a vehicle is collected by a sound collection unit (microphone) and a change amount of an average volume of the sound in the vehicle for a given time is a positive value, a conversation is determined to start and the information sound is stopped. In a case in which the change amount is 0 (zero) or a negative value, the conversation is determined to converge and reproduction of the information sound is performed. Japanese Laid-open Patent Publication No. 2004-48570 is an example of related art.

In a case in which the technology of related art is applied to a technology in which the above-described wearable headset is worn and sound information is reproduced, the surrounding sound of a user is collected by a sound collection unit. In this technology, in a case in which a change amount of the average volume of the surrounding sound for a given time is a positive value, reproduction of the sound information is stopped. In a case in which the change amount is 0 (zero) or a negative value, the reproduction of the sound information is performed.

In a technology for switching reproduction of sound information and stop of the reproduction according to a change amount of the average volume, however, it may be sometimes erroneously determined that a user has a conversation even in a case in which people around the user have conversation. In this case, even when the user does not have conversation, the reproduction of the sound information is stopped. Therefore, the user may not hear the sound information.

It may not normally be true that the problem that the user may not hear the sound information occurs only in technologies for using wearable headsets, as described above. This problem can also occur in, for example, technologies for reproducing sound information by personal computers (PCs) without wearing headsets such as wearable headsets or technologies for reproducing sound information by acoustic devices in vehicles. This problem can occur not only in situations in which users have conversation or have no conversation but also in situations in which users have no conversation and are interested or not interested in simply surrounding situations. Further, this problem can occur not only in technologies for reproducing sound information but also in technologies for reproducing (displaying) various kinds of content such as moving-image information excluding sound information.

An object of the technology of the present disclosure is to reproduce content in a more proper state as one aspect of the technology.

SUMMARY

According to an aspect of the invention, a content reproduction device includes: a sound acquisition unit that acquires a first sound around an user; an reaction detection unit that detects an reaction of the user; a within-period reaction determination unit that determines that there is a within-period reaction in a case in which the reaction is detected within a predetermined period from an acquisition time point of the first sound based on a temporal relation between the first sound and the detected reaction; and a reproduction control unit that performs control such that reproduction of content is restricted or performs control such that a part of the content reproduced within a period in which the detection of the reaction within the predetermined period continues is reproduced again after the period in the case in which the within-period reaction determination unit determines that there is the within-period reaction.

BRIEF DESCRIPTION OF DRAWINGS

FIG. 1 is a functional block diagram illustrating a basic configuration of a content reproduction device according to an embodiment;

FIG. 2 is a schematic diagram illustrating description of a principle of a content reproduction function according to the embodiment;

FIG. 3 is a flowchart illustrating an example of the content reproduction process according to the embodiment;

FIG. 4 is a flowchart illustrating an example of an output mode determination process according to the embodiment;

FIG. 5 is a flowchart illustrating an example of a return determination process according to the embodiment;

FIG. 6 is a functional block diagram illustrating a server and a terminal according to a first embodiment;

FIG. 7 is a table illustrating an example of a storage state in a buffer memory of sound content according to the first embodiment;

FIG. 8 is a block diagram illustrating a schematic configuration of a computer system according to the first embodiment:

FIG. 9 is a flowchart illustrating an example of terminal processing according to the first embodiment;

FIG. 10 is a flowchart illustrating an example of a content reproduction process according to the first embodiment;

FIG. 11 is a flowchart illustrating an example of an output mode determination process according to the first embodiment;

FIG. 12 is a flowchart illustrating an example of a return determination process according to the first embodiment;

FIG. 13 is a flowchart illustrating an example of an output process according to the first embodiment;

FIG. 14 is a functional block diagram illustrating a server and a terminal according to a second embodiment;

FIG. 15 is a table illustrating an example of a storage state in a buffer memory of sound content according to the second embodiment;

FIG. 16 is a block diagram illustrating a schematic configuration of a computer system according to the second embodiment;

FIG. 17 is a flowchart illustrating an example of a content reproduction process according to the second embodiment;

FIG. 18 is a flowchart illustrating an example of a return determination process according to the second embodiment;

FIG. 19 is a flowchart illustrating an example of a server process according to the second embodiment;

FIG. 20 is a functional block diagram illustrating a terminal according to a third embodiment;

FIG. 21 is a block diagram illustrating a schematic configuration of the terminal according to the third embodiment;

FIG. 22 is a flowchart illustrating an example of a content reproduction process according to the third embodiment;

FIG. 23 is a flowchart illustrating an example of an output process according to the third embodiment;

FIG. 24 is a functional block diagram illustrating a terminal according to a fourth embodiment;

FIG. 25 is a block diagram illustrating a schematic configuration of the terminal according to the fourth embodiment;

FIG. 26 is a flowchart illustrating an example of a content reproduction process according to the fourth embodiment;

FIG. 27 is a flowchart illustrating an example of an output process according to the fourth embodiment;

FIG. 28 is a functional block diagram illustrating a server and a terminal according to a fifth embodiment;

FIG. 29 is a block diagram illustrating a schematic configuration of a computer system according to the fifth embodiment;

FIG. 30 is a flowchart illustrating an example of an output mode determination process according to the fifth embodiment;

FIG. 31 is a functional block diagram illustrating a server and a terminal according to a sixth embodiment;

FIG. 32 is a block diagram illustrating a schematic configuration of a computer system according to the sixth embodiment;

FIG. 33 is a flowchart illustrating an example of an output mode determination process according to the sixth embodiment;

FIG. 34 is a flowchart illustrating an example of a return determination process according to the sixth embodiment;

FIG. 35 is a functional block diagram illustrating a server and a terminal according to a seventh embodiment;

FIG. 36 is a block diagram illustrating a schematic configuration of a computer system according to the seventh embodiment;

FIG. 37 is a flowchart illustrating an example of a return determination process according to the seventh embodiment;

FIG. 38 is a functional block diagram illustrating a server and a terminal according to an eighth embodiment;

FIG. 39 is a block diagram illustrating a schematic configuration of a computer system according to the eighth embodiment;

FIG. 40 is a flowchart illustrating an example of an output mode determination process according to the eighth embodiment;

FIG. 41 is a flowchart illustrating an example of a return determination process according to the eighth embodiment; and

FIG. 42 is a flowchart illustrating an example of an output process according to the eighth embodiment.

DESCRIPTION OF EMBODIMENTS

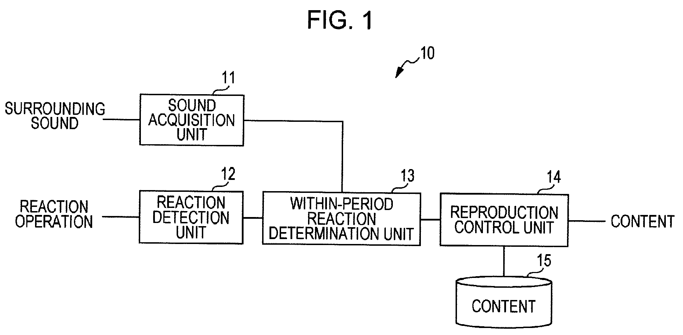

Hereinafter, examples of embodiments of the technology of the present disclosure will be described in detail with reference to the drawings. In FIG. 1, a basic configuration of a content reproduction device 10 according to an embodiment is illustrated. As illustrated in FIG. 1, the content reproduction device 10 according to the embodiment includes a sound acquisition unit 11, an reaction detection unit 12, a within-period reaction determination unit 13, and a reproduction control unit 14.

The sound acquisition unit 11 acquires a surrounding sound of a user of the content reproduction device 10 as a first sound and detects a voice section contained in the surrounding sound. The reaction detection unit 12 detects a reaction of the user to the surrounding sound. Based on a temporal relation between the surrounding sound of the user acquired by the sound acquisition unit 11 and the reaction detected by the reaction detection unit 12, the within-period reaction determination unit 13 determines that there is an reaction within-period (the reaction is also referred to as "within-period reaction" herein after) in the following case. The case is a case in which the reaction is detected within a predetermined period from a time point at which the surrounding sound of the user is acquired. The reproduction control unit 14 performs control such that reproduction of content is restricted in a case in which within-period reaction determination unit 13 determines that there is the reaction within the period.

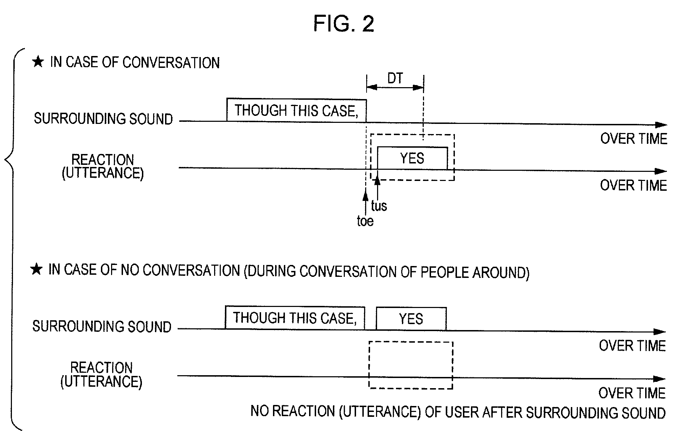

That is, as illustrated in FIG. 2, for example, in a case in which the user of the content reproduction device 10 has conversation with a person around the user, the user performs a certain reaction to a surrounding sound (in the example illustrated in FIG. 2, an utterance from a person around the user such as "Though this case...,"). That is, in this case, the user performs a certain reaction (in the example illustrated in FIG. 2, an utterance such as "Yes") within a period, starting at when a voice section included in the surrounding sound starts and ending at after a predetermined time DT (for example, 4 seconds) that is a relatively short time following the voice section. This period is referred to as a "reaction determination period."

On the other hand, in a case in which the user has no conversation with a person around the user and people around the user have conversation, the user does not perform the foregoing reaction to a surrounding sound.

Based on such reactions, first, the sound acquisition unit 11 in the content reproduction device 10 according to the embodiment acquires a surrounding sound of the user of the content reproduction device 10 and detects a voice section contained in the surrounding sound. The reaction detection unit 12 in the content reproduction device 10 detects a reaction to the surrounding sound of the user. Next, the within-period reaction determination unit 13 in the content reproduction device 10 determines that there is a reaction within a period in a case in which the reaction detection unit 12 detects the reaction within a predetermined period from the voice section detected by the sound acquisition unit 11. Then, in a case in which the within-period reaction determination unit 13 determines that there is the reaction within the period, the reproduction control unit 14 in the content reproduction device 10 performs control such that, for example, reproduction of content stored in a storage unit 15 is restricted.

Examples of the reaction to the surrounding sound of the user include not only the reaction performed by an utterance described with reference to FIG. 2 but also a reaction performed by a change in the direction of a head, a reaction performed by vibration of a head in the vertical or horizontal direction, and a reaction performed by movement of a visual line. Examples of the reaction to the surrounding sound of the user also include a reaction performed by a change in an input frequency of a keyboard in a case in which the user manipulates the keyboard and a reaction performed by movement of the user.

Here, the reaction by an utterance is performed when the user speaks to a conversation partner to deliver a user's opinion or intention to the conversation partner. The reaction performed by a change in the direction of a head, that is, looking back, is performed when the user orients his or her head ahead in a direction in which a partner is present to look at the face of the partner. The reaction performed by vibration of a head is performed by a so-called body language when the user assents (nods with an intention of "Yes") or rejects (swings with an intention of "No") to simplify his or her intention to a partner. The reaction performed by movement of a visual line is generated when the user orients his or her visual line to a partner to see the face of the partner. The reaction performed by a change in an input frequency to a keyboard (delaying a keyboard input) is generated when the user stops an input or slows an input speed of the keyboard in the middle of conversation to concentrate on the conversation. The reaction performed by movement of the user is generated when the user moves close to a partner of conversation in the middle of the conversation since a distance to the partner of the conversation is distant and a sound does not arrive and it is hard to see the face of the partner, and thus the conversation is difficult.

In the content reproduction device 10, the sound acquisition unit 11 is an example of a sound acquisition unit related to the technology of the present disclosure and the reaction detection unit 12 is an example of an reaction detection unit related to the technology of the present disclosure. In the content reproduction device 10, the within-period reaction determination unit 13 is an example of a within-period reaction determination unit related to the technology of the present disclosure and the reproduction control unit 14 is an example of a reproduction control unit related to the technology of the present disclosure.

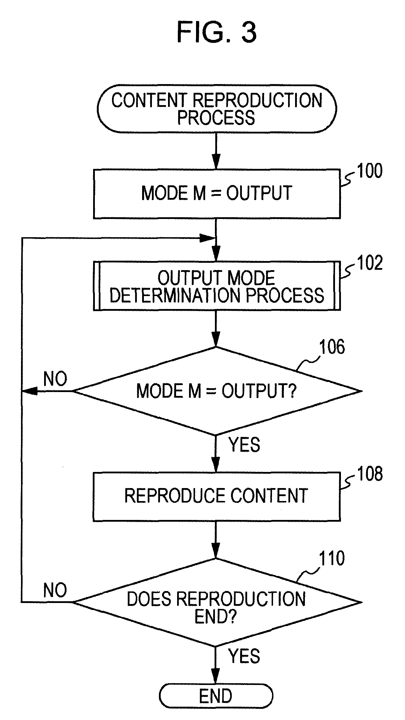

The content reproduction device 10 according to the embodiment performs control such that reproduction of content stored in the storage unit 15 is restricted, for example, a content reproduction process illustrated in FIG. 3 is performed, in a case in which the user is estimated to be interested in a surrounding sound.

Next, operational effects of the content reproduction device 10 in a case in which the content reproduction process is performed will be described with reference to FIG. 3. Here, a case in which control of stopping the reproduction of the content is performed as an example of control of restricting the reproduction of content will be described. Here, to avoid complication, a case in which information indicating content to be reproduced is stored in the storage unit 15 will be described.

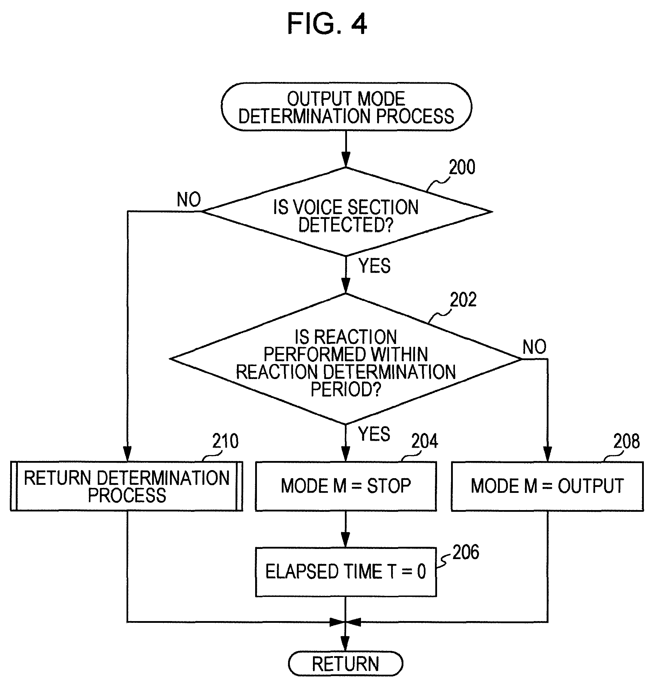

In step 100 of the content reproduction process, the reproduction control unit 14 sets a value indicating "output" representing reproduction of content as a default value for a variable M which is a variable for setting a content reproduction mode. In subsequent step 102, the reproduction control unit 14 performs an output mode determination process illustrated in FIG. 4.

In step 200 of the output mode determination process, the sound acquisition unit 11 determines whether a voice section which is a section in which a sound is pronounced from the surrounding of the user of the content reproduction device 10 is detected. In a case in which the determination is positive, the process proceeds to step 202. In step 202, the reaction detection unit 12 attempts to detect a reaction to the surrounding sound of the user. Then, in step 202, the within-period reaction determination unit 13 determines whether there is the reaction within the period, that is, whether the user is estimated to be interested in the surrounding sound of the user, by determining whether the user performs the reaction within the reaction determination period. In the case in which the determination is positive, the process proceeds to step 204.

In step 204, the reproduction control unit 14 sets a value indicating "stop" representing stop of the reproduction of the content in the variable M. In subsequent step 206, the reproduction control unit 14 clears a variable T which is a variable indicating an elapsed time (sets 0 (zero) in the embodiment) and subsequently ends the output mode determination process. In a case in which the determination is negative in step 202, the process proceeds to step 208. Then, the reproduction control unit 14 sets the value indicating the "output" described above in the variable M and subsequently ends the output mode determination process.

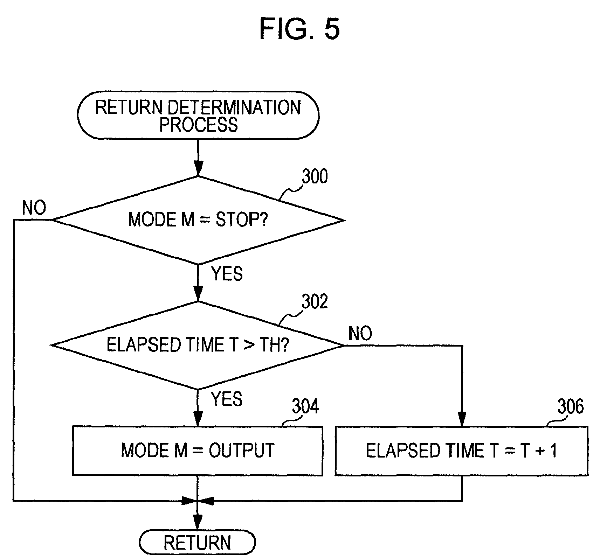

Conversely, in a case in which determination is negative in step 200, the process proceeds to step 210. Then, the reproduction control unit 14 performs a return determination process illustrated in FIG. 5.

In step 300 of the return determination process, the reproduction control unit 14 determines whether the value indicating "stop" described above in the variable M is set. In a case in which the determination is positive, the process proceeds to step 302. In step 302, the reproduction control unit 14 determines whether the value of the variable T exceeds a predetermined threshold value TH. In a case in which the determination is positive, the process proceeds to step 304. Then, the reproduction control unit 14 sets the value indicating the "output" described above in the variable M and subsequently ends the return determination process.

Conversely, in a case in which the determination is negative in step 302, the process proceeds to step 306. Then, the reproduction control unit 14 increases the value of the variable T by a predetermined value ('1' in the embodiment) and subsequently ends the return determination process. In a case in which the determination is negative in step 300, the return determination process ends without performing the processes of the foregoing steps 302 to 306. When the return determination process ends, the output mode determination process illustrated in FIG. 4 ends. When the output mode determination process ends, the process proceeds to step 106 of the content reproduction process illustrated in FIG. 3.

In the return determination process related to the embodiment, in a case in which the value of the variable T indicating the elapsed time after the stop of the reproduction of content exceeds the threshold value TH, a process of automatically resuming the reproduction of the content is performed. Accordingly, the threshold value TH used in the process of step 302 of the return determination process is set in advance as the value of the variable T corresponding to a desired period until the reproduction of the stopped content is automatically resumed.

In step 106 of the content reproduction process, the reproduction control unit 14 determines whether the value indicating the "output" described above is set in the variable M. In a case in which the determination is negative, the process returns to step 102. Conversely, in a case in which the determination is positive, the process proceeds to step 108.

In step 108, the reproduction control unit 14 reads information regarding a predetermined unit quantity from information indicating the content stored in the storage unit 15 and reproduces the information. In subsequent step 110, the reproduction control unit 14 determines whether the reading and reproduction of all the information indicating the content to be reproduced from the storage unit 15 ends. Here, in a case in which the determination is negative, the process returns to step 102. Conversely, at a time point at which the determination is positive, the content reproduction process ends.

More specific embodiments corresponding to the foregoing basic embodiment will be described in detail with reference to the drawings.

(First Embodiment)

In a first embodiment, a case in which the content reproduction device 10 is applied to a system including a server, a terminal (client), a wearable headset (hereinafter simply referred to as a "headset"), and a recorder will be described. In the first embodiment, a case in which a desktop PC is applied as a terminal will be described.

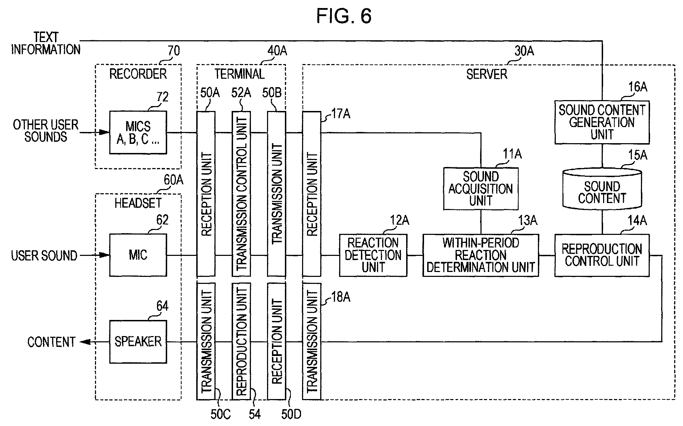

FIG. 6 illustrates a server 30A, a terminal 40A, a headset 60A, and a recorder 70 according to the embodiment. As illustrated in FIG. 6, the server 30A according to the embodiment includes a sound acquisition unit 11A, an reaction detection unit 12A, a within-period reaction determination unit 13A, a reproduction control unit 14A, a buffer memory 15A, a sound content generation unit 16A, a reception unit 17A, and a transmission unit 18A. The terminal 40A includes a reception unit 50A, a transmission unit 50B, a transmission unit 50C, a reception unit 50D, a transmission control unit 52A, and a reproduction unit 54. The headset 60A includes a microphone (hereinafter referred to as a "mic") 62 and a speaker 64. The recorder 70 includes a plurality of mics 72.

The plurality of mics 72 included in the recorder 70 are provided around a user of the terminal 40A and each collect a surrounding sound of the user and output audio data indicating the sound. In the embodiment, directional mics present around the terminal 40A and used by a plurality of users (hereinafter referred to as "other users") other than the user of the terminal 40A are applied as the plurality of mics 72, but the disclosure is not limited thereto. For example, non-directional mics collectively collecting sounds of a plurality of other users may be applied as the mics 72.

On the other hand, the mic 62 included in the headset 60A collects an utterance of the user of the terminal 40A and is provided in the headset 60A to be close to the mouth of the user when the headset 60A is worn by the user of the terminal 40A. In the embodiment, a directional mic collecting a sound arriving in the direction of the mouth of the user with high precision is used as the mic 62, but the disclosure is not limited thereto. A non-directional mic may be used as the mic 62 depending on distances between the user of the terminal 40A and other users, the number of other users, or the like. The speaker 64 included in the headset 60A is provided in the headset 60A to be close to an ear of the user when the headset 60A is worn by the user of the terminal 40A.

The plurality of mics 72 of the recorder 70 are connected to the reception unit 50A of the terminal 40A, and thus sound data obtained by collecting the sound by each mic 72 is transmitted to the terminal 40A. The mic 62 of the headset 60A is also connected to the reception unit 50A of the terminal 40A, and sound data obtained by collecting the sound by the mic 62 is also transmitted to the terminal 40A. The speaker 64 of the headset 60A is connected to the transmission unit 50C of the terminal 40A, and thus the speaker 64 reproduces the sound according to the sound data transmitted from the terminal 40A.

The transmission unit 50B of the terminal 40A is connected to the reception unit 17A of the server 30A and the reception unit 50D of the terminal 40A is connected to the transmission unit 18A of the server 30A.

The transmission control unit 52A of the terminal 40A transmits the sound data received from each mic 72 of the recorder 70 and the mic 62 of the headset 60A via the reception unit 50A to the server 30A via the transmission unit 50B. The reproduction unit 54 outputs the sound data received from the server 30A via the reception unit 50D to the speaker 64 of the headset 60A via the transmission unit 50C. Accordingly, the speaker 64 reproduces the sound indicated by the sound data received from the terminal 40A.

On the other hand, the sound acquisition unit 11A of the server 30A corresponds to the sound acquisition unit 11 described above and acquires the surrounding sound of the user by acquiring the sound data (hereinafter referred to as "surrounding sound data") obtained by the plurality of mics 72 of the recorder 70 via the terminal 40A. The sound acquisition unit 11A according to the embodiment learns (stores), as sound data indicating background noise, the sound data obtained by the plurality of mics 72 in advance in a state in which the user of the terminal 40A or other users do not perform an reaction of speaking sounds such as conversation or a sound of movement. The sound acquisition unit 11A obtains a signal-to-noise ratio (SNR), which is a ratio of the sound data obtained by each mic 72 to the sound data indicating the noise obtained by the corresponding mic 72, for each of the mics 72. Then, the sound acquisition unit 11A detects a section in which the obtained SNR is equal to or greater than a predetermined threshold value as a voice section around the user of the terminal 40A. Accordingly, the voice sections can be detected in a state in which a partial period or all the period overlaps up to the same number as the maximum number of the mics 72. The voice section included in the surrounding sound is referred to as a "surrounding voice section" below.

The reaction detection unit 12A corresponds to the reaction detection unit 12 described above and acquires the sound data (hereinafter referred to as "user sound data") obtained by the mic 62 of the headset 60A via the terminal 40A. Then, the reaction detection unit 12A detects a reaction to the surrounding sound of the user of the terminal 40A based on the acquired user sound data. The reaction detection unit 12A according to the embodiment learns (stores), as sound data indicating background noise, the sound data obtained by the mic 62 in advance in a state in which the user of the terminal 40A or other users do not perform an reaction of speaking sounds such as conversation or a sound of movement. The reaction detection unit 12A detects a section in which the SNR, which is a ratio of the sound data obtained by the mic 62 to the sound data indicating the noise, is equal to or greater than a predetermined threshold value as a voice section (a reaction) by an utterance of the user of the terminal 40A. The voice section included in the user sound data is referred to as a "user voice section" below. Since the SNR is disclosed in Japanese Laid-open Patent Publication No. 2014-228753 by the inventors of the technology of the present disclosure, the further description thereof will be omitted here.

In the embodiment, the threshold value used when the surrounding voice section is detected in the sound acquisition unit 11A is set to be the same as the threshold value used when the user voice section is detected in the reaction detection unit 12A, but the disclosure is not limited thereto. The threshold values may be different from each other according to a difference in the sound collection characteristics between the mics 62 and 72, distances between the user of the terminal 40A and the other users, or the number of other users.

On the other hand, the within-period reaction determination unit 13A corresponds to the within-period reaction determination unit 13 described above and determines whether the reaction detection unit 12A detects a reaction within a predetermined period from a time point at which the sound acquisition unit 11A detects the voice section (surrounding voice section). This determination corresponds to a process of estimating whether the user is interested in the surrounding sound. In a case in which the condition expressed in the following formula (1) is satisfied, the within-period reaction determination unit 13A according to the embodiment determines that the user of the terminal 40A has conversation with other users and there is the reaction within the period performed by the user of the terminal 40A. This determination corresponds to a process of estimating whether the user of the terminal 40A is interested in the surrounding sound. As illustrated also in FIG. 2, toe in formula (1) indicates an end time of the surrounding voice section, tus indicates a start time of the user voice section, and DT indicates a predetermined time, as described above.

$$(toe + DT) > tus \qquad (1)$$

That is, formula (1) indicates that the start time tus of the user voice section is included in a period (reaction determination period) from the start time of the surrounding voice section to a time obtained by adding the predetermined time DT to the end time toe of the surrounding voice section, and corresponds to "the case of conversation" of FIG. 2. In the embodiment, the longest period (for example, 4 seconds) assumed as a time taken from the end time toe of the surrounding voice section to start of an utterance of the user of the terminal 40A according to the sound of the surrounding voice section is applied fixedly as the predetermined time DT. However, the disclosure is not limited thereto. For example, the predetermined time DT may be appropriately changed according to the degree of fatigue of the user of the terminal 40A or a kind of content in a case in which the user of the terminal 40A reproduces some content with the terminal 40A.

Here, in the embodiment, as described above, a plurality of surrounding voice sections are detected to correspond to the plurality of mics 72 in a state in which a partial period or all the period overlaps in some cases. In this case, in the embodiment, a period from the earliest time among the start times of the plurality of surrounding voice sections to a time obtained by adding the predetermined time DT to the latest time among the end times toe of the plurality of surrounding voice sections is applied as the reaction determination period. However, the disclosure is not limited to this form. For example, the reaction determination period may be derived for each of the plurality of surrounding voice sections. In this case, in a case in which the condition expressed in formula (1) is satisfied for at least one period among the reaction determination periods, for example, the form in which it is determined that there is the reaction within the period performed by the user of the terminal 40A can be applied.

On the other hand, the sound content generation unit 16A generates content of a sound (hereinafter referred to as "sound content") according to input information to the terminal 40A by the user of the terminal 40A. The sound content generation unit 16A according to the embodiment generates, as the sound content, the sound data for which text information is read aloud by an electronic mail transmitted to the user of the terminal 40A.

The buffer memory 15A is a storage region in which the sound data generated by the sound content generation unit 16A is temporarily stored. In the embodiment, a memory with a first-in first-out (FIFO) format is used as the buffer memory 15A. The sound content generation unit 16A according to the embodiment stores the sound data for which the text information is read aloud in the buffer memory 15A in predetermined units. At this time, the sound content generation unit 16A stores new sound data in a subsequent address of the sound data stored finally in the buffer memory 15A at that time point. Examples of the predetermined units include mora units, word units, phase units, sentence units, paragraph units, and event units. In the embodiment, phrase units are applied as the predetermined units.

The buffer memory 15A reads the sound data corresponding to one frame from an address indicated by a reading pointer and outputs the sound data to the reproduction control unit 14A. Then, the buffer memory 15A updates the reading pointer to an address in which the subsequent sound data of the read sound data is stored at a time point at which the reading of the sound data corresponding to one frame ends.

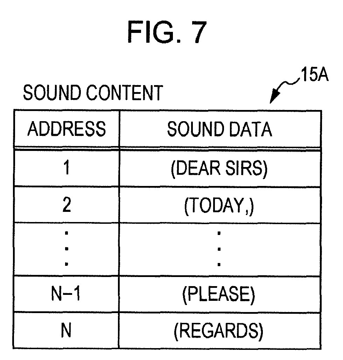

FIG. 7 schematically illustrates sound data of the sound content stored in the buffer memory 15A. In the example illustrated in FIG. 7, the sound data of the sound content is stored in the buffer memory 15A in order chronologically from the beginning address in phrase units of "dear Sirs;", "Today,", ..., "Please ...", and "Regards,".

The reproduction control unit 14A corresponds to the reproduction control unit 14 described above and performs control such that reproduction of content is restricted in the case in which the within-period reaction determination unit 13A determines that there is the reaction within the period. The reproduction control unit 14A according to the embodiment stops reproducing the sound content in the case in which the within-period reaction determination unit 13A determines that there is the reaction within the period. In other cases, the reproduction control unit 14A performs control such that the reproduction of the sound content continues.

On the other hand, the transmission control unit 52A of the terminal 40A controls transmission of the surrounding sound data received from each mic 72 of the recorder 70 and the user sound data received from the mic 62 of the headset 60A to the server 30A. The reproduction unit 54 causes the speaker 64 of the headset 60A to reproduce the sound content under the control of the reproduction control unit 14A of the server 30A.

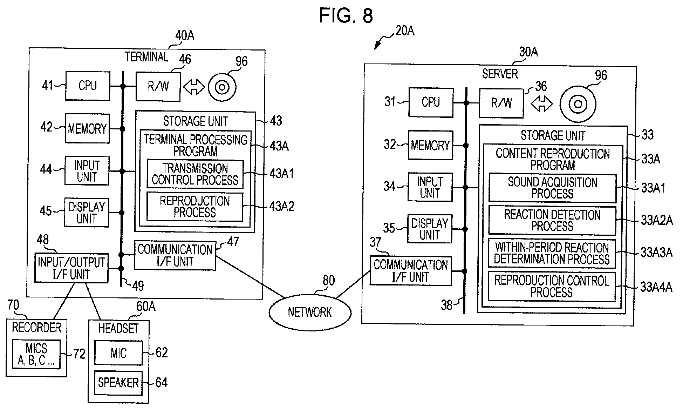

The server 30A and the terminal 40A described above can be respectively realized by a server 30A and a terminal 40A included in a computer system 20A illustrated in FIG. 8. The computer system 20A according to the embodiment includes the server 30A and the terminal 40A considered to access a network 80.

The server 30A includes a central processing unit (CPU) 31, a memory 32, a storage unit 33, an input unit 34, a display unit 35, a medium reading/writing device (R/W) 36, and a communication interface (I/F) unit 37. The CPU 31, the memory 32, the storage unit 33, the input unit 34, the display unit 35, the medium reading/writing device 36, and the communication I/F unit 37 are connected to each other via a bus 38. The medium reading/writing device 36 reads information written on a recording medium 96 and writes information on the recording medium 96. The above-described buffer memory 15A is included in the memory 32.

The storage unit 33 can be realized by a hard disk drive (HDD), a flash memory, or the like. The storage unit 33 stores a content reproduction program 33A that causes the server 30A to function as the server 30A illustrated in FIG. 6. The content reproduction program 33A is stored in the storage unit 33 when the recording medium 96 on which the content reproduction program 33A is written is set in the medium reading/writing device 36 and the medium reading/writing device 36 reads the content reproduction program 33A from the recording medium 96. The CPU 31 reads the content reproduction program 33A from the storage unit 33 and loads the content reproduction program 33A on the memory 32, and then sequentially executes processes included in the content reproduction program 33A.

The content reproduction program 33A includes a sound acquisition process 33A1, an reaction detection process 33A2A, a within-period reaction determination process 33A3A, and a reproduction control process 33A4A. The CPU 31 operates as the sound acquisition unit 11A illustrated in FIG. 6 by executing the sound acquisition process 33A1. The CPU 31 operates as the reaction detection unit 12A illustrated in FIG. 6 by executing the reaction detection process 33A2A. The CPU 31 operates as the within-period reaction determination unit 13A illustrated in FIG. 6 by executing the within-period reaction determination process 33A3A. The CPU 31 operates as the reproduction control unit 14A illustrated in FIG. 6 by executing the reproduction control process 33A4A.

As described above, the server 30A executing the content reproduction program 33A functions as the server 30A illustrated in FIG. 6. The content reproduction program 33A is an example of a content reproduction program according to the technology of the present disclosure.

On the other hand, the terminal 40A includes a CPU 41, a memory 42, a storage unit 43, an input unit 44, a display unit 45, a medium reading/writing device 46, a communication I/F unit 47, and an input/output I/F unit 48. The CPU 41, the memory 42, the storage unit 43, the input unit 44, the display unit 45, the medium reading/writing device 46, the communication I/F unit 47, and the input/output I/F unit 48 are connected to each other via a bus 49. The medium reading/writing device 46 reads information written on the recording medium 96 and writes information on the recording medium 96.

The storage unit 43 can be realized by an HDD, a flash memory, or the like. The storage unit 43 stores a terminal processing program 43A that causes the terminal 40A to function as the terminal 40A illustrated in FIG. 6.

The terminal processing program 43A is stored in the storage unit 43 when the recording medium 96 on which the terminal processing program 43A is written is set in the medium reading/writing device 46 and the medium reading/writing device 46 reads the terminal processing program 43A from the recording medium 96. The CPU 41 reads the terminal processing program 43A from the storage unit 43 and loads the terminal processing program 43A on the memory 42, and then sequentially executes processes included in the terminal processing program 43A.

The terminal processing program 43A includes a transmission control process 43A1 and a reproduction process 43A2. The CPU 41 operates as the transmission control unit 52A illustrated in FIG. 6 by executing the transmission control process 43A1. The CPU 41 operates the reproduction unit 54 illustrated in FIG. 6 by executing the reproduction process 43A2.

As described above, the terminal 40A executing the terminal processing program 43A functions as the terminal 40A illustrated in FIG. 6.

In the computer system 20A according to the embodiment, various kinds of information are transmitted and received between the server 30A and the terminal 40A via a network 80, but the disclosure is not limited thereto. For example, various kinds of information may be transmitted and received directly or by wired or wireless communication between the server 30A and the terminal 40A. In the computer system 20A, various kinds of information are transmitted and received between the server 30A and the terminal 40A, and other devices connected to the network 80 by wired communication by the communication I/F units provided in the server 30A and the terminal 40A, but the disclosure is not limited thereto. For example, various kinds of information may be transmitted and received between at least one of the server 30A and the terminal 40A and other devices connected to the network 80 by wireless communication.

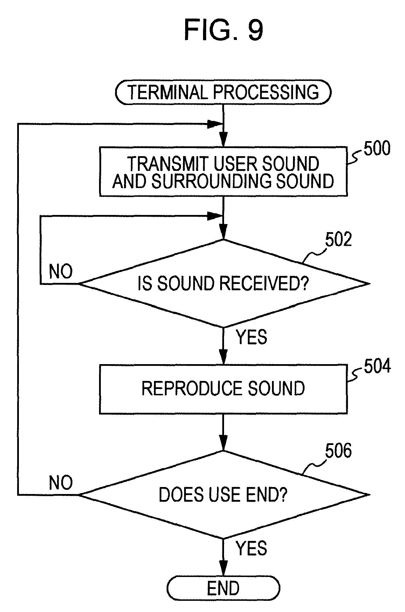

Next, operational effects of the embodiment will be described. Hereinafter, a case will be assumed in which sound content is reproduced using the terminal 40A in a state in which the user of the terminal 40A wears the headset 60A connected to the terminal 40A. In this case, the user of the terminal 40A performs terminal processing illustrated in FIG. 9 by causing the terminal 40A to execute the terminal processing program 43A.

In step 500 of the terminal processing, the transmission control unit 52A starts transmitting the surrounding sound data received from each mic 72 of the recorder 70 and the user sound data received from the mic 62 of the headset 60A to the server 30A in real time. On the other hand, as will be described below, the server 30A transmits the sound data for which the sound content (text information by an electronic mail) generated by the sound content generation unit 16A and stored in the buffer memory 15A is read aloud to the terminal 40A for each frame.

Accordingly, in subsequent step 502, the reproduction unit 54 waits to receive the sound data corresponding to one frame from the server 30A. When the sound data is received, the determination is positive and the process proceeds to step 504.

In step 504, the reproduction unit 54 reproduces the sound indicated by the sound data by transmitting the sound data received from the server 30A to the speaker 64 of the headset 60A. In subsequent step 506, the reproduction unit 54 determines whether the use of the terminal 40A by the user ends. In a case in which the determination is negative, the process returns to step 500. At a time point at which the determination is positive, the terminal processing ends. In the embodiment, whether the use of the terminal 40A ends is determined in step 506 by determining whether an instruction given by the user to end the use of the terminal processing is input via the input unit 44, but the disclosure is not limited thereto. For example, whether the use of the terminal 40A ends may be determined, for example, by determining whether a power switch of the terminal 40A is considered to be turned off.

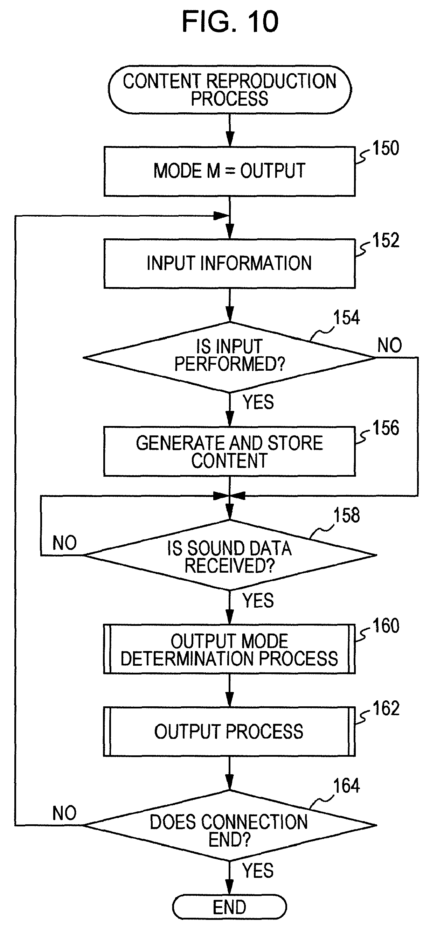

On the other hand, the server 30A performs a content reproduction process illustrated in FIG. 10 by executing the content reproduction program 33A when the access from the terminal 40A starts.

In step 150 of the content reproduction process, the reproduction control unit 14A sets a value indicating "output" representing the reproduction of content as a default value in the variable M which is a variable for setting the content reproduction mode. In subsequent step 152, the sound content generation unit 16A attempts to input text information by an electronic mail newly received for the user of the terminal 40A from a predetermined mail server. In subsequent step 154, the sound content generation unit 16A determines whether the text information is input from the mail server. In a case in which the determination is negative, the process proceeds to step 158 to be described below. Conversely, in a case in which the determination is positive, the process proceeds to step 156.

In step 156, the sound content generation unit 16A generates the sound data in which the text information input from the mail server is read aloud and stores the sound data in a predetermined storage region of the memory 32. At this time, when the sound content generation unit 16A starts executing the content reproduction process and executes step 156 for the first time, the sound content generation unit 16A sets a reading pointer corresponding to the storage region (hereinafter referred to as a "first reading pointer") in the beginning address of the predetermined storage region.

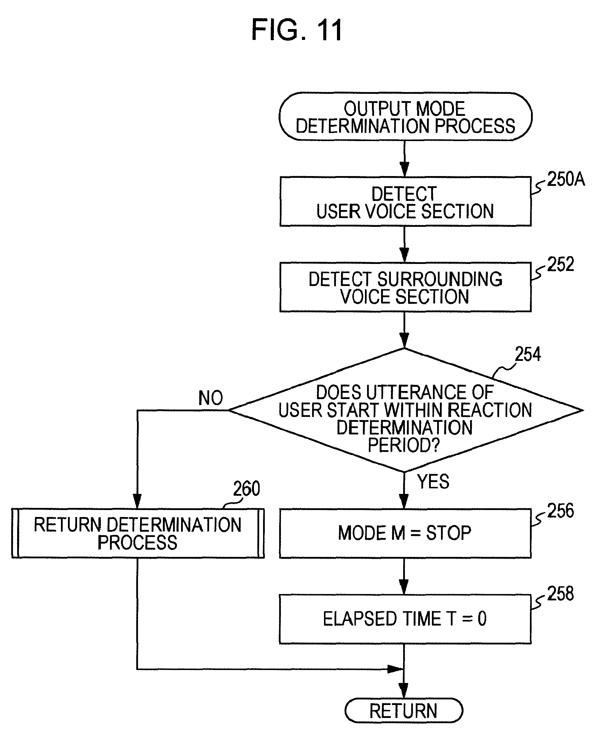

In subsequent step 158, the sound acquisition unit 11A and the reaction detection unit 12A wait to receive predetermined amounts of surrounding sound data and user sound data from the terminal 40A. In a case in which the determination is positive in step 158, the process proceeds to step 160. In step 160, the reproduction control unit 14A performs an output mode determination process illustrated in FIG. 11.

In step 250A of the output mode determination process, the reaction detection unit 12A attempts to detect the user voice section from the user sound data. In subsequent step 252, the sound acquisition unit 11A attempts to detect the surrounding voice section from the surrounding sound data. In subsequent step 254, the within-period reaction determination unit 13A determines whether the user voice section and the surrounding voice section are detected and the condition expressed in formula (1) described above is satisfied in the detected user voice section and surrounding voice section. Here, in a case in which the determination is positive, it is considered that there is the reaction within the period performed by the user of the terminal 40A and the process proceeds to step 256.

In step 256, the reproduction control unit 14A sets the value indicating "stop" representing the stop of the reproduction of the content in the variable M. In subsequent step 258, the reproduction control unit 14A clears the variable T which is the variable indicating the elapsed time (sets 0 (zero) in the embodiment) and subsequently ends the output mode determination process.

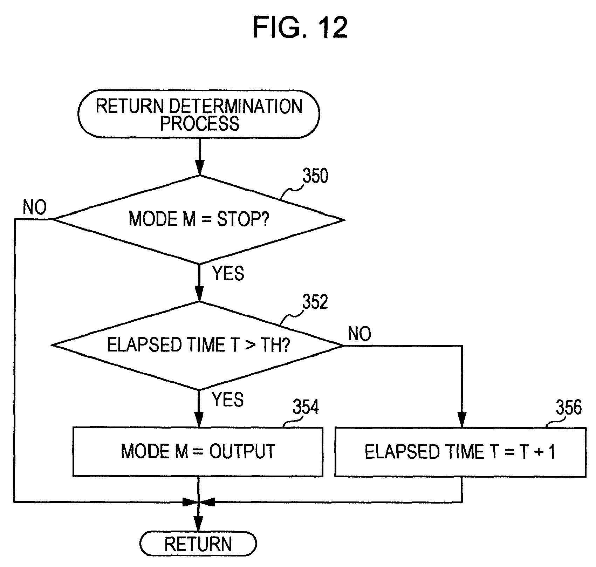

Conversely, in a case in which the determination is negative in step 254, the process proceeds to step 260 and the reproduction control unit 14A performs a return determination process illustrated in FIG. 12.

In step 350 of the return determination process, the reproduction control unit 14A determines whether the value indicating "stop" described above in the variable M is set. In a case in which the determination is positive, the process proceeds to step 352. In step 352, the reproduction control unit 14A determines whether the value of the variable T exceeds a predetermined threshold value TH. In a case in which the determination is positive, the process proceeds to step 354. Then, the reproduction control unit 14A sets the value indicating the "output" described above in the variable M and subsequently ends the return determination process. The threshold value TH applied in the process of step 352 is, for example, the same as the threshold value TH applied in the process of step 302 of the return determination process illustrated in FIG. 5.

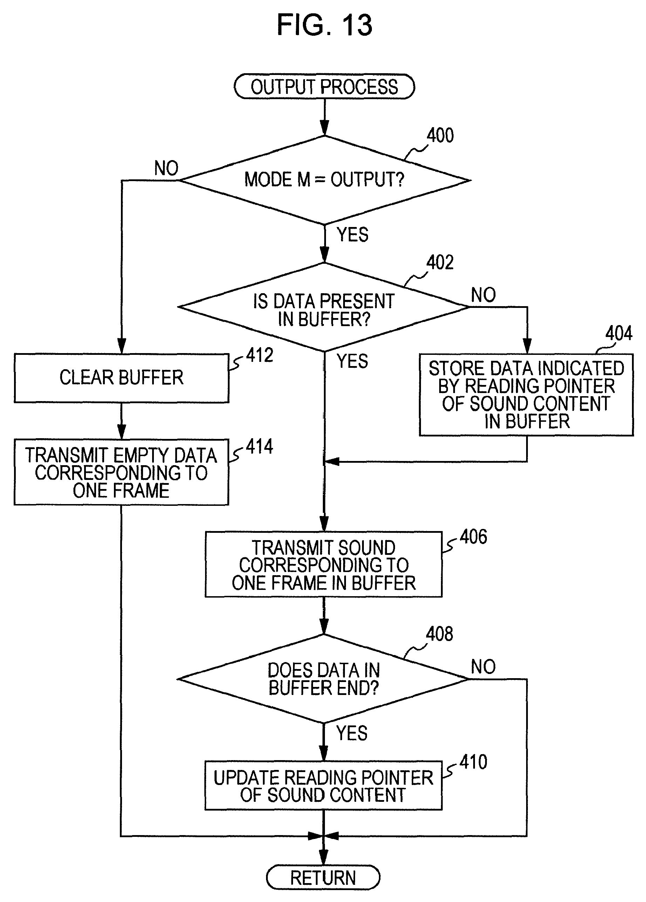

Conversely, in a case in which the determination is negative in step 352, the process proceeds to step 356. Then, the reproduction control unit 14A increases the value of the variable T by a predetermined value ('1' in the embodiment) and subsequently ends the return determination process. In a case in which the determination is negative in step 350, the return determination process ends without performing the processes of the foregoing steps 352 to 356. When the return determination process ends, the output mode determination process illustrated in FIG. 11 ends. When the output mode determination process ends, the process proceeds to step 162 of the content reproduction process illustrated in FIG. 10. The reproduction control unit 14A performs an output process illustrated in FIG. 13.

In step 400 of the output process, the reproduction control unit 14A determines whether the "output" described above is set in the variable M. In a case in which the determination is positive, the process proceeds to step 402. In step 402, the reproduction control unit 14A determines whether the sound data is stored in the buffer memory 15A. In a case in which the determination is positive, the process proceeds to step 406 to be described below. Conversely, in a case in which the determination is negative, the process proceeds to step 404.

In step 404, the reproduction control unit 14A reads the sound data stored in the address indicated by the first reading pointer of the memory 32 by the amount of the predetermined units and stores the sound data in the buffer memory 15A. Thereafter, the process proceeds to step 406. At this time, when the reproduction control unit 14A starts performing the content reproduction process and executes step 404 for the first time, the reproduction control unit 14A sets a reading pointer corresponding to the buffer memory 15A (hereinafter referred to as a "second reading pointer") in the beginning address of the buffer memory 15A.

In step 406, the reproduction control unit 14A reads the sound data corresponding to one frame stored in the address indicated by the second reading pointer of the buffer memory 15A from the buffer memory 15A and transmits the sound data to the terminal 40A. In subsequent step 408, the reproduction control unit 14A determines whether the transmission of all the sound data stored in the buffer memory 15A to the terminal 40A ends. In a case in which the determination is negative, the output process ends. Conversely, in a case in which the determination is positive, the process proceeds to step 410. In step 410, the reproduction control unit 14A updates the value of the first reading pointer (increases only an address corresponding to the amount of the predetermined units) and subsequently ends the output process.

Conversely, in a case in which the determination is negative in step 400, the process proceeds to step 412 and the reproduction control unit 14A clears the buffer memory 15A. In subsequent step 414, the reproduction control unit 14A transmits empty data corresponding to one frame as sound data to the terminal 40A and subsequently ends the output process. When the output process ends, the process proceeds to step 164 of the content reproduction process illustrated in FIG. 10.

In step 164, the reproduction control unit 14A determines whether the access from the terminal 40A ends. In a case in which the determination is negative, the process returns to step 152. Conversely, at a time point at which the determination is positive, the content reproduction process ends.

As described in detail above, in the embodiment, the surrounding sound of the user is acquired by the sound acquisition unit 11, the voice section included in the surrounding sound is detected, and the reaction to the surrounding sound of the user is detected by the reaction detection unit 12. In the embodiment, the within-period reaction determination unit 13 determines that there is the reaction within the period in the case in which the reaction detection unit 12 detects the reaction within the predetermined period from the time point at which the sound acquisition unit 11 detects the voice section. In the embodiment, the reproduction control unit 14 performs the control such that the reproduction of the content is restricted in the case in which the within-period reaction determination unit 13 determines that there is the reaction within the period, that is, the user can be estimated to be interested in the surrounding sound. Therefore, in the embodiment, the content can be reproduced in a more proper state compared to the technology of related art in which a reaction of a user to a surrounding sound is not considered.

In the embodiment, the reaction detection unit 12 detects an utterance reaction of the user as a reaction. Accordingly, it is possible to perform the control such that the reproduction of the content is restricted in the state in which the user utters.

In the embodiment, the user is estimated to be interested in the surrounding sound by determining that there is the reaction within the period in the case in which the reaction is detected within the period (the reaction determination period) in which the time point at which the voice section of the acquired surrounding sound starts is set as a starting point and the time point at which the voice section ends and the predetermined time passes is set as an ending point. Accordingly, by appropriately setting the predetermined time according to the personality of the user, a surrounding situation of the user, or the like, it is possible to appropriately estimate whether the user is interested in the surrounding sound.

In the embodiment, in the case in which it is determined that there is the reaction within the period and subsequently the reaction is not detected within the reaction determination period, the user is estimated not to be interested in the surrounding sound by determining that there is no reaction within the period. In the embodiment, in the case in which there is no reaction within the period, the control performed such that there is the reaction within the period is cancelled. Accordingly, in the case in which it is determined that there is no reaction within the period, that is, the user is estimated not to be interested in the surrounding sound, the content can be reproduced as in the normal case. Consequently, it is possible to improve convenience for the user.

In the embodiment, the reproduction control unit 14 performs control such that the reproduction of the content stops in the case in which the within-period reaction determination unit 13 estimates that the user is interested in the surrounding sound. In the embodiment, the reproduction control unit 14 performs control such that the reproduction of the content resumes in a case in which the reproduction control unit 14 performs the control such that the reproduction of the content stops and the within-period reaction determination unit 13 estimates that the user is not interested in the surrounding sound. Accordingly, it is possible to more appropriately stop and resume the reproduction of the content.

Further, in the embodiment, the reaction detection unit 12 detects the reaction as the reaction in which the magnitude (the SNR in the embodiment) of a sound generated through an utterance reaction of the user is equal to or greater than a predetermined threshold value. Accordingly, it is possible to more appropriately detect the reaction by the utterance of the user.

(Second Embodiment)

In a second embodiment, a case will be described in which the content reproduction device 10 is applied to a system including a server, a terminal (client) internally including a mic, and a headset.

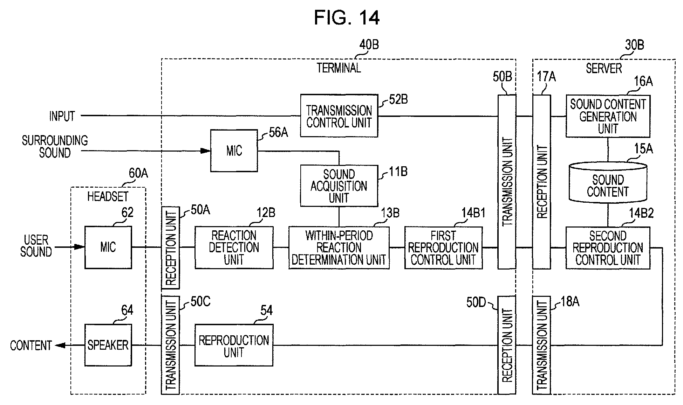

FIG. 14 illustrates a server 30B, a terminal 40B, and a headset 60A according to the embodiment. The same reference numerals as those of FIG. 6 are given to the same constituent elements in FIG. 14 as those of FIG. 6, and the description thereof will be omitted as much as possible.

As illustrated in FIG. 14, the terminal 40B according to the embodiment is different from the terminal 40A according to the first embodiment in that the transmission control unit 52A is configured as a transmission control unit 52B performing a different process from the transmission control unit 52A. The terminal 40B according to the embodiment is also different from the terminal 40A according to the first embodiment in that a sound acquisition unit 11B, an reaction detection unit 12B, a within-period reaction determination unit 13B, a first reproduction control unit 14B1, and a mic 56A are newly provided. On the other hand, the server 30B according to the embodiment is different from the server 30A according to the first embodiment in that the sound acquisition unit 11A, the reaction detection unit 12A, and the within-period reaction determination unit 13A are not provided. The server 30B according to the embodiment is different from the server 30A according to the first embodiment in that the reproduction control unit 14A is configured as a second reproduction control unit 14B2 performing a different process from the reproduction control unit 14A. In the embodiment, the recorder 70 is not used.

The transmission control unit 52B of the terminal 40B performs control such that information designating content desired to be reproduced by the speaker 64 of the headset 60A is transmitted to the server 30B. The mic 56A collects a surrounding sound of a user and outputs sound data indicating the sound. In the embodiment, a non-directional mic is applied as the mic 56A.

The sound acquisition unit 11B corresponds to the sound acquisition unit 11 described above and acquires a surrounding sound of the user by acquiring the sound data (surrounding sound data) obtained by the mic 56A. The sound acquisition unit 11B according to the embodiment learns (stores), as sound data indicating background noise, the sound data obtained by the mics 56A in advance in a state in which the user of the terminal 40B or other users do not perform an reaction of speaking sounds such as conversation or a sound of movement. Then, the sound acquisition unit 11B detects a section in which the SNR, which is a ratio of the sound data obtained by the mic 56A to the sound data indicating the noise, is equal to or greater than a predetermined threshold value as a voice section (a surrounding voice section) around the user of the terminal 40B.

The reaction detection unit 12B corresponds to the reaction detection unit 12 described above and acquires the sound data (user sound data) obtained by the mic 62 of the headset 60A. Then, the reaction detection unit 12B detects a reaction to the surrounding sound of the user of the terminal 40B based on the acquired user sound data. The reaction detection unit 12B according to the embodiment learns (stores), as sound data indicating background noise, the sound data obtained by the mics 62 in advance in a state in which the user of the terminal 40B or other users do not perform an reaction of speaking sounds such as conversation or a sound of movement. Then, the reaction detection unit 12B detects a section in which the SNR, which is a ratio of the sound data obtained by the mic 62 to the sound data indicating the noise, is equal to or greater than a predetermined threshold value as a voice section (a user voice section) by an utterance of the user of the terminal 40B.

In the embodiment, the threshold value used when the surrounding voice section is detected in the sound acquisition unit 11B is set to be the same as the threshold value used when the user voice section is detected in the reaction detection unit 12B, but the disclosure is not limited thereto. The threshold values may be different from each other according to a difference in the sound collection characteristics between the mics 56A and 62, distances between the user of the terminal 40B and the other users, or the number of other users.

Further, the within-period reaction determination unit 13B corresponds to the within-period reaction determination unit 13 described above. The within-period reaction determination unit 13B determines whether there is an reaction within a period or there is no reaction within a period based on whether the user voice section (a reaction by an utterance) is detected by the reaction detection unit 12B within a predetermined period from a time point at which the sound acquisition unit 11B detects the voice section. In the case in which the condition expressed in formula (1) described above is satisfied, the within-period reaction determination unit 13B according to the embodiment can also estimate that the user of the terminal 40B is interested in the surrounding sound by determining that the user of the terminal 40B has conversation with other users and there is the reaction within the period.

On the other hand, the first reproduction control unit 14B1 of the terminal 40B and the second reproduction control unit 14B2 of the server 30B correspond to the reproduction control unit 14 described above. The first reproduction control unit 14B1 and the second reproduction control unit 14B2 cooperate to perform control such that the reproduction of content is restricted in the case in which the within-period reaction determination unit 13B of the terminal 40B determines that there is the reaction within the period, that is, in the case in which the user can be estimated to be interested in the surrounding sound. The first reproduction control unit 14B1 and the second reproduction control unit 14B2 according to the embodiment stop reproducing the sound content in the case in which the user is estimated to be interested in the surrounding sound and perform control such the reproduction of the sound content continues in other case.

The sound content generation unit 16A of the server 30B according to the embodiment generates, as content, the sound data in which web news selected in advance by the user using the terminal 40B is read aloud.

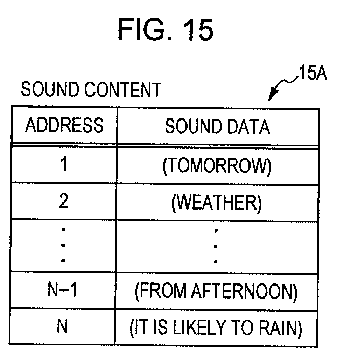

FIG. 15 schematically illustrates sound data of the sound content stored in the buffer memory 15A. In the example illustrated in FIG. 15, the sound data of the sound content is stored in the buffer memory 15A in order chronologically from the beginning address in phrase units of "Tomorrow", "Weather", ..., "From afternoon", and "It is likely to rain".

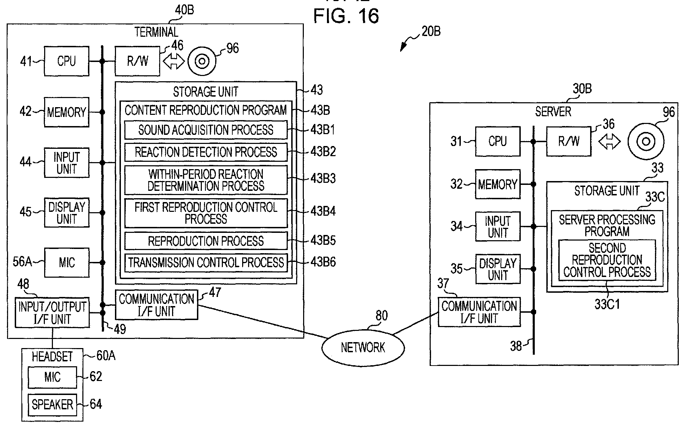

The server 30B and the terminal 40B described above can be respectively realized by the server 30B and the terminal 40B included in the computer system 20B illustrated in FIG. 16. The same reference numerals as those of FIG. 8 are given to the same constituent elements in FIG. 16 as those of FIG. 8, and the description thereof will be omitted as far as possible.

As illustrated in FIG. 16, in the storage unit 33 of the server 30B according to the embodiment, a server processing program 33C causing the server 30B to function as the server 30B illustrated in FIG. 14 is stored instead of the content reproduction program 33A. The server processing program 33C is stored in the storage unit 33 when the recording medium 96 on which the server processing program 33C is written is set in the medium reading/writing device 36 and the medium reading/writing device 36 reads the server processing program 33C from the recording medium 96. The CPU 31 reads the server processing program 33C from the storage unit 33 and loads the server processing program 33C on the memory 32, and then sequentially execute processes included in the server processing program 33C.

The server processing program 33C includes a second reproduction process 33C1. The CPU 31 operates as the second reproduction control unit 14B2 illustrated in FIG. 14 by executing the second reproduction process 33C1.

As described above, the server 30B executing the server processing program 33C functions as the server 30B illustrated in FIG. 14. The server processing program 33C includes some of the processes of the content reproduction program according to the technology of the present disclosure.

On the other hand, as illustrated in FIG. 16, in the terminal 40B according to the embodiment, the mic 56A is connected to the bus 49. In the storage unit 43 of the terminal 40B according to the embodiment, the content reproduction program 43B causing the terminal 40B to function as the terminal 40B illustrated in FIG. 14 is stored instead of the terminal processing program 43A. The content reproduction program 43B is stored in the storage unit 43 when the recording medium 96 on which the content reproduction program 43B is written is set in the medium reading/writing device 46 and the medium reading/writing device 46 reads the content reproduction program 43B from the recording medium 96. The CPU 41 reads the content reproduction program 43B from the storage unit 43 and loads the content reproduction program 43B on the memory 42, and then sequentially executes processes included in the content reproduction program 43B.

The content reproduction program 43B includes a sound acquisition process 43B1, an reaction detection process 43B2, a within-period reaction determination process 43B3, a first reproduction control process 43B4, a reproduction process 43B5, and a transmission control process 43B6. The CPU 41 operates as the sound acquisition unit 11B illustrated in FIG. 14 by executing the sound acquisition process 43B1. The CPU 41 operates as the reaction detection unit 12B illustrated in FIG. 14 by executing the reaction detection process 43B2. The CPU 41 operates as the within-period reaction determination unit 13B illustrated in FIG. 14 by executing the within-period reaction determination process 43B3. The CPU 41 operates as the first reproduction control unit 14B1 illustrated in FIG. 14 by executing the first reproduction control process 43B4. The CPU 41 operates as the reproduction unit 54 illustrated in FIG. 14 by executing the reproduction process 43B5. The CPU 41 operates as the transmission control unit 52B illustrated in FIG. 14 by executing the transmission control process 43B6.

As described above, the terminal 40B executing the content reproduction program 43B functions as the terminal 40B illustrated in FIG. 14. The content reproduction program 43B includes some of the processes of the content reproduction program according to the technology of the present disclosure.

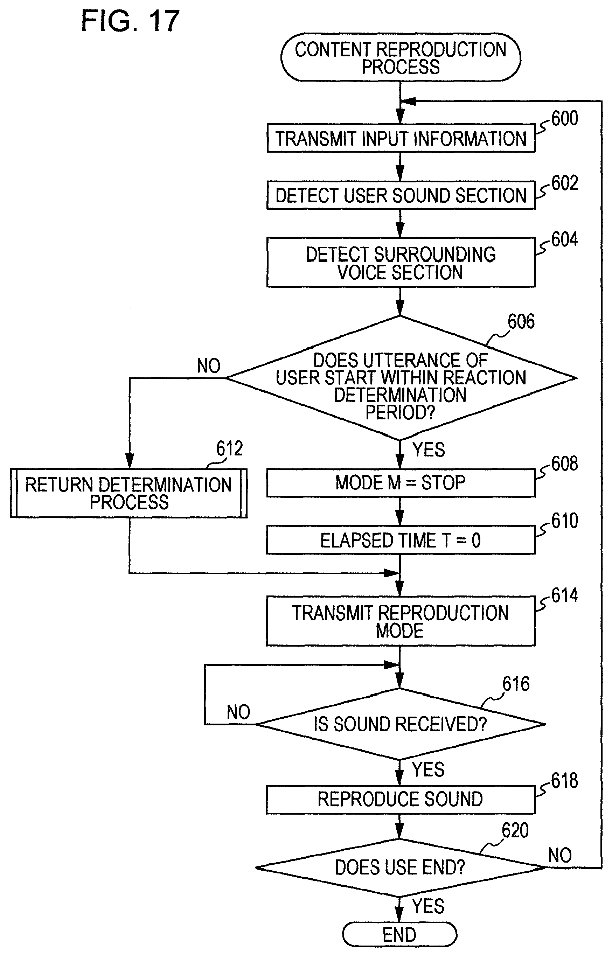

Next, operational effects of the embodiment will be described. Hereinafter, a case will be assumed in which sound content is reproduced using the terminal 40B in a state in which the user of the terminal 40B wears the headset 60A connected to the terminal 40B. In this case, the user of the terminal 40B performs the content reproduction process illustrated in FIG. 17 by causing the terminal 40B to execute the content reproduction program 43B. Hereinafter, to avoid complication, a case will be described in which specific information (Uniform Resource Locators (URL) in the embodiment) for specifying plurality of pieces of web news desired to be reproduced with the terminal 40B by the user of the terminal 40B is input to the terminal 40B in advance.

In step 600 of the content reproduction process, the transmission control unit 52B transmits information designating web news of one case (hereinafter referred to as "web designation information") included in the specific information to the server 30B.

In subsequent step 602, the reaction detection unit 12B attempts to detect the user voice section from the user sound data. In subsequent step 604, the sound acquisition unit 11B attempts to detect the surrounding voice section from the surrounding sound data. In subsequent step 606, the within-period reaction determination unit 13B determines whether the user voice section and the surrounding voice section are detected and the condition expressed in formula (1) described above is satisfied in the detected user voice section and surrounding voice section. Here, in a case in which the determination is positive, it is determined that there is the reaction within the period, that is, the user of the terminal 40B is considered to be interested in the surrounding sound. Then, the process proceeds to step 608.

In step 608, the first reproduction control unit 14B1 sets the value indicating "stop" representing the stop of the reproduction of the content in the variable M which is a variable for setting the content reproduction mode. In subsequent step 610, the first reproduction control unit 14B1 clears the variable T which is the variable indicating the elapsed time (sets 0 (zero) in the embodiment) and subsequently the process proceeds to step 614.

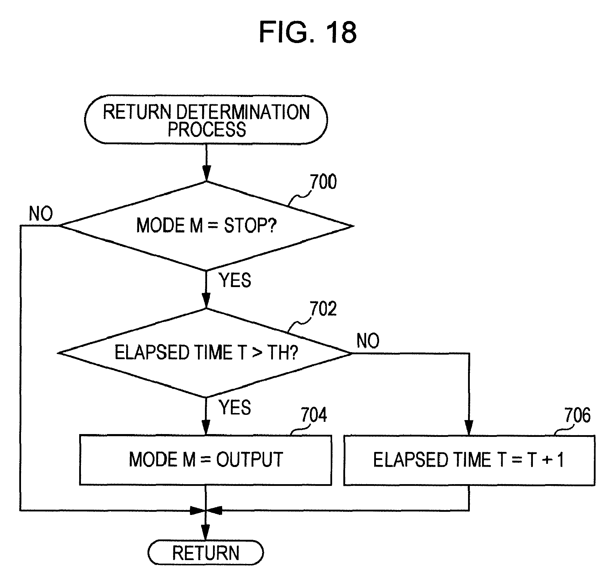

Conversely, in a case in which the determination in step 606 is negative, the process proceeds to step 612 and the first reproduction control unit 14B1 performs a return determination process illustrated in FIG. 18.

In step 700 of the return determination process, the first reproduction control unit 14B1 determines whether the value indicating "stop" described above is set in the variable M. In a case in which the determination is positive, the process proceeds to step 702. In step 702, the first reproduction control unit 14B1 determines whether the value of the variable T exceeds a predetermined threshold value TH. In a case in which the determination is positive, the process proceeds to step 704. Then, the first reproduction control unit 14B1 sets the value indicating the "output" in the variable M and subsequently ends the return determination process. The threshold value TH applied in the process of step 702 is, for example, the same as the threshold value TH applied in the process of step 302 of the return determination process illustrated in FIG. 5.

Conversely, in a case in which the determination is negative in step 702, the process proceeds to step 706. Then, the first reproduction control unit 14B1 increases the value of the variable T by a predetermined value ('1' in the embodiment) and subsequently ends the return determination process. In a case in which the determination is negative in step 700, the return determination process ends without performing the processes of the foregoing steps 702 to 706. When the return determination process ends, the process proceeds to step 614 of the content reproduction process illustrated in FIG. 17.

In step 614, the first reproduction control unit 14B1 transmits the value set in the variable M through the foregoing process as reproduction mode information to the server 30B.

On the other hand, when the server 30B receives the web designation information from the terminal 40B, the server 30B acquires the web news designated by the received web designation information via the network 80, the Internet, or the like. The server 30B generates sound data in which the acquired web news is read aloud, temporarily stores the sound data in the buffer memory 15A, and then sequentially transmits the sound data the terminal 40B. At this time, the server 30B transmits the sound data in which the web news is read aloud to the terminal 40B for each frame so that the web news is reproduced in the reproduction mode indicated by the reproduction mode information received from the terminal 40B.

Accordingly, in subsequent step 616, the reproduction unit 54 waits to receive the sound data for each frame from the server 30B. When the sound data is received, the determination is positive and the process proceeds to step 618.

In step 618, the reproduction unit 54 reproduces the sound indicated by the sound data by transmitting the sound data received from the server 30B to the speaker 64 of the headset 60A. In subsequent step 620, the reproduction unit 54 determines whether the use of the terminal 40B by the user ends. In a case in which the determination is negative, the process returns to step 600. At a time point at which the determination is positive, the content reproduction process ends. Here, when the processes of steps 600 to 620 are repeatedly performed, the transmission control unit 52B transmits, to the server 30B, the web designation information designating the web news which has not still transmitted at that time in the specific information in the process of step 600.

In the embodiment, whether the use of the terminal 40B ends is determined in step 620 by determining whether the web designation information corresponding to all the web news specified by the specific information is transmitted to the server 30B. However, the disclosure is not limited thereto. For example, whether the use of the terminal 40B ends may be determined by determining whether an instruction given by the user to end the use of the content reproduction process is input via the input unit 44. For example, whether the use of the terminal 40B ends may be determined by determining whether a power switch of the terminal 40B is considered to be turned off.

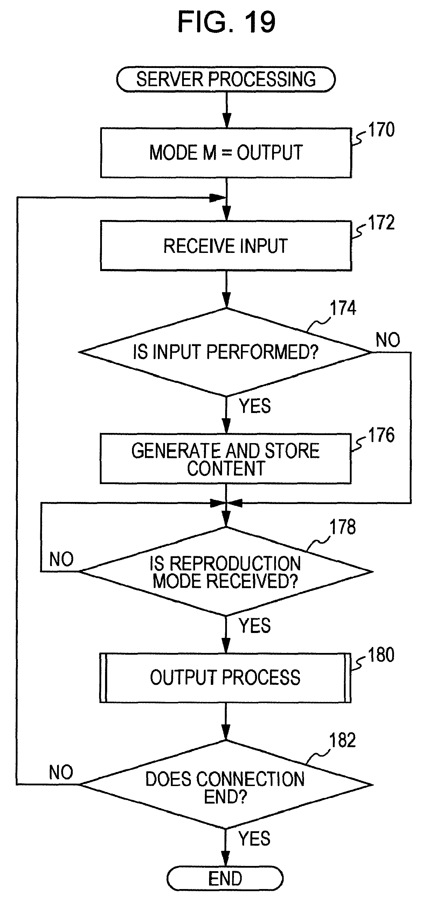

On the other hand, the server 30B performs server processing illustrated in FIG. 19 by executing the server processing program 33C when the access from the terminal 40B starts (in the embodiment, when the web designation information is received).

In step 170 of the server processing, the second reproduction control unit 14B2 sets a value indicating "output" representing the reproduction of content as a default value in the variable M. In subsequent step 172, the sound content generation unit 16A attempts to receive the web news designated by the web designation information received from the terminal 40B. In subsequent step 174, the sound content generation unit 16A determines whether the web news is received. In a case in which the determination is negative, the process proceeds to step 178 to be described below. Conversely, in a case in which the determination is positive, the process proceeds to step 176.

In step 176, the sound content generation unit 16A generates the sound data in which the received web news is read aloud and stores the sound data in a predetermined storage region of the memory 32. At this time, when the sound content generation unit 16A starts executing the server processing and executes step 176 for the first time, the sound content generation unit 16A sets a first reading pointer corresponding to the storage region in the beginning address of the predetermined storage region.

In subsequent step 178, the second reproduction control unit 14B2 waits to receive the reproduction mode information from the terminal 40B. In a case in which the determination is positive in step 178, the received reproduction mode information is substituted into the variable M, and subsequently the process proceeds to step 180. In step 180, the second reproduction control unit 14B2 performs an output process illustrated in FIG. 13. The output process is the same as that of the first embodiment, and thus the description thereof will be omitted here. When the output process ends, the process proceeds to step 182 of the server processing illustrated in FIG. 19.

In step 182, the second reproduction control unit 14B2 determines whether the access from the terminal 40B ends. In a case in which the determination is negative, the process returns to step 172. Conversely, at a time point at which the determination is positive, the server processing ends.

As described in detailed above, in the embodiment, it is possible to obtain the same advantages as those of the first embodiment and the surrounding sound data and the user sound data from the terminal 40B to the server 30B may not be transmitted. Therefore, it is possible to reduce a communication amount of the transmission.

(Third Embodiment)

In a third embodiment, a case will be described in which the content reproduction device 10 is applied to a system including a headset and a terminal internally including a mic array and a camera.

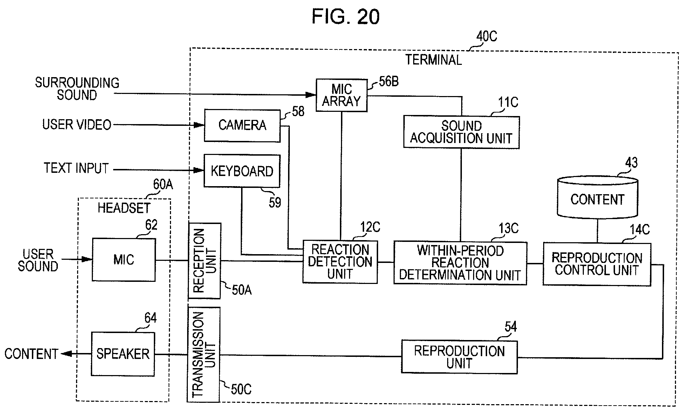

FIG. 20 illustrates a terminal 40C and a headset 60A according to the embodiment. The same reference numerals as those of FIG. 14 are given to the same constituent elements in FIG. 20 as those of FIG. 14, and the description thereof will be omitted as much as possible.

As illustrated in FIG. 20, the terminal 40C according to the embodiment is different from the terminal 40B according to the second embodiment in that a camera 58 and a keyboard 59 are newly provided and the transmission unit 50B and the reception unit 50D are not provided. The terminal 40C according to the embodiment is different from the terminal 40B according to the second embodiment in that a mic array 56B is provided instead of the mic 56A.

The terminal 40C according to the embodiment is different from the terminal 40B according to the second embodiment in that the sound acquisition unit 11B is configured as a sound acquisition unit 11C performing a different process from the sound acquisition unit 11B. The terminal 40C according to the embodiment is different from the terminal 40B according to the second embodiment in that the reaction detection unit 12B is configured as an reaction detection unit 12C performing a different process from the reaction detection unit 12B. The terminal 40C according to the embodiment is different from the terminal 40B according to the second embodiment in that the within-period reaction determination unit 13B is configured as a within-period reaction determination unit 13C performing a different process from the within-period reaction determination unit 13B. The terminal 40C according to the embodiment is different from the terminal 40C according to the second embodiment in that the first reproduction control unit 14B1 is configured as a reproduction control unit 14C performing a different process from the first reproduction control unit 14B1.

Further, the terminal 40C according to the embodiment is different from the terminal 40B according to the second embodiment in that content is stored in the storage unit 43. In the embodiment, the server 30B is not used.

In the mic array 56B of the terminal 40C, a plurality of mic elements are arranged abreast, and each mic element collects a surrounding sound of a user of the terminal 40C and outputs sound data indicating the sound. The camera 58 can photograph the face of the user of the terminal 40C. In the embodiment, the camera 58 is provided in an upper portion of the display unit 45 in the terminal 40C, but the disclosure is not limited thereto. The position of the camera 58 may be any position as long as the face of the user of the terminal 40C can be photographed.

The sound acquisition unit 11C according to the embodiment corresponds to the sound acquisition unit 11 described above and acquires a surrounding sound of the user by acquiring the sound data (surrounding sound data) obtained by the plurality of mic elements of the mic array 56B. The sound acquisition unit 11C according to the embodiment learns (stores), as sound data indicating background noise, the sound data obtained by each mic element in advance in a state in which the user of the terminal 40C or other users do not perform an reaction of speaking sounds such as conversation or a sound of movement. Then, the sound acquisition unit 11C obtains the SNR, which is a ratio of the sound data obtained by each mic element to the sound data indicating the noise obtained by the corresponding mic element, for each mic element. The sound acquisition unit 11C detects a section in which the SNR is equal to or greater than a predetermined threshold value as a voice section (a surrounding voice section) around the user of the terminal 40C. Accordingly, the surrounding voice section can be detected up to the maximum number of mic elements in a state in which a partial period or all the period overlaps in some cases.

The reaction detection unit 12C corresponds to the reaction detection unit 12 described above and acquires the sound data (surrounding sound data) obtained by the mic array 56B in addition to the sound data (user sound data) obtained by the mic 62 of the headset 60A. The reaction detection unit 12C acquires image data indicating a surrounding video obtained through photographing with the camera 58 (hereinafter referred to as "user image data"). The reaction detection unit 12C acquires a signal indicating an input state of the keyboard 59 by the user (hereinafter referred to as a "keyboard input signal"). Then, the reaction detection unit 12C detects a reaction to the surrounding sound of the user of the terminal 40C based on the acquired user sound data, the acquired surrounding sound data, the acquired user image data, and the acquired keyboard input signal.

The reaction detection unit 12C according to the embodiment learns (stores), as sound data indicating background noise, the sound data obtained by the mics 62 in advance in a state in which the user of the terminal 40C or other users do not perform an reaction of speaking sounds such as conversation or a sound of movement. Then, the reaction detection unit 12C detects a section in which the SNR, which is a ratio of the sound data obtained by the mic 62 to the sound data indicating the noise, is equal to or greater than a predetermined threshold value as a voice section (a user voice section) by an utterance of the user of the terminal 40C.

The reaction detection unit 12C estimates the direction of a surrounding sound source of the terminal 40C based on the plurality of pieces of surrounding sound data obtained by the mic array 56B. The estimation of the direction of the sound source can be realized using a known technology of related art, such as a technology described in Oikawa, et al, "Optimization of Estimation of Sound Source Direction Using Matching Pursuit", Journal of Acoustical Society of Japan, September 2005. Therefore, the detailed description of a method of estimating the direction of a sound source will be omitted here. Hereinafter, the direction of a sound source estimated at time t is assumed to be oa(t).

The reaction detection unit 12C detects the direction of the head of the user in real time from an image of the face of the user of the terminal 40C indicated by the user image data, using a technology of related art, such as a technology disclosed in, for example, Japanese Laid-open Patent Publication No. 2007-200298. The reaction detection unit 12C detects an reaction of the head of the user as follows based on the estimated direction oa(t) of the sound source and the detected direction of the head of the user.

That is, based on the user image data, the reaction detection unit 12C first obtains an angle of the direction of the head when an angle of the body of the user of the terminal 40C in the front direction is assumed to be 0 (zero). Here, an angle obtained at time t in the horizontal direction is assumed to be h(t) and an angle in the vertical direction is assumed to be v(t). For the angle in the horizontal direction, a right hand side of the user is in the range of +1 degree to +179 degrees, a left hand side is in the range of -1 degree to -179 degrees, and a rear direction is $\pm 180$ degrees. For the angle in the vertical direction, an upper side is in the range of +1 degree to +90 degrees and a lower side is in the range of -1 degree to -90 degrees.

Next, the reaction detection unit 12C determines that the head of the user performs an reaction (hereinafter referred to as a "head reaction") as a reaction of the user of the terminal 40C to a surrounding sound in a case in which formulae (2) to (5) below satisfy at least one of the following conditions.

$$(oa(t-a)+TH\_RT)>h(t)>(oa(t-a)-TH\_RT) \text{ and } |h(t-a)|<TH\_ST, a <DH \quad (2)$$

$$v(t-b-c)-v(t-b)>TH\_RT2 \text{ and } v(t)-v(t-b)>TH\_RT2, b<DH2, c<DH2 \quad (3)$$

$$h(t-b-c)-h(t-b)>TH\_RT3 \text{ and } h(t)-h(t-b)>TH\_RT3, b<DH2, c<DH2 \quad (4)$$

$$h(t-b)-h(t-b-c)>TH\_RT3 \text{ and } h(t-b)-h(t)>TH\_RT3, b<DH2, c<DH2 \quad (5)$$

Formula (2) indicates a condition in a case in which the head of the user performs an reaction of orienting in a direction (oa(t - a)) of a sound source within a range defined by a threshold value TH_RT within a given time DH from a state ($|h(t - a)| < TH\_ST$) in which the head is oriented toward the front side within a predetermined range defined by a threshold value TH_ST (hereinafter referred to as a look-back reaction). Formula (3) indicates a condition in a case in which the head of the user performs an reaction of orienting in the lower direction beyond an angle defined by a threshold value TH_RT2 within a given time DH2 and subsequently orienting in the upper direction beyond the angle within the given time DH2 (hereinafter referred to as a "a node reaction"). Formulae (4) and (5) indicate a condition in a case in which the head of the user performs an reaction of orienting in one of the right and left directions beyond an angle defined by a threshold value TH_RT3 within the given time DH2 and subsequently orienting the other of the right and left directions beyond the angle within the given time DH2 (hereinafter referred to as a "swing reaction").

The reaction detection unit 12C detects the direction of a visual line of the user in real time from an image of the face of the user of the terminal 40C indicated by the user image data using a known technology of related art, such as a technology disclosed in, for example, Japanese Laid-open Patent Publication No. 2014-39617. In a case in which the same condition as that of the look-back reaction expressed in formula (2) described above is satisfied, the reaction detection unit 12C determines that the visual line of the user operates as a reaction reaction of the user of the terminal 40C to the surrounding sound (hereinafter referred to as a "visual line reaction reaction"). Here, in a case in which whether the condition of formula (2) is successful is determined, the direction of the head is substituted with the direction of the visual line.

The reaction detection unit 12C determines a seating situation of the user from the image of the face of the user of the terminal 40C indicated by the user image data, using a known technology of related art, such as a technology disclosed in, for example, Japanese Patent No. 5204323. In a case in which the seating state of the user is changed to a non-seating state of the user, the reaction detection unit 12C determines that the body of the user moves as the reaction of the user of the terminal 40C to the surrounding sound (hereinafter referred to as a "movement reaction ").

Further, the reaction detection unit 12C derives an average value of key input numbers (hereinafter referred to as an "average input number") per a predetermined time (per second in the embodiment) based on a keyboard input signal. The reaction detection unit 12C determines whether the average input number after elapse of a predetermined period (2 seconds in the embodiment) decreases by a predetermined threshold value (50% of the average input number before the elapse in the embodiment) or more from the average input number before the elapse. In a case in which the reaction detection unit 12C determines that the average input number decreases by the predetermined threshold value or more, the reaction detection unit 12C determines that a reaction of decreasing the input number on the keyboard 59 of the user, that is, delay of the keyboard input, occurs as the reaction of the user of the terminal 40C to the surrounding sound (hereinafter referred to as a "keyboard reaction ").

In the embodiment, the threshold value used when the surrounding voice section is detected in the sound acquisition unit 11C is also set to be the same as the threshold value used when the user voice section is detected in the reaction detection unit 12C, but the disclosure is not limited thereto. The threshold values may be different from each other according to a difference in the sound collection characteristics between the mic array 56B and the mic 62, distances between the user of the terminal 40C and the other users, or the number of other users.

On the other hand, the within-period reaction determination unit 13C corresponds to the within-period reaction determination unit 13 described above and determines whether there is the reaction within the period or there is no reaction within the period by determining whether the reaction detection unit 12C detects the reaction within the predetermined period from a time point at which the sound acquisition unit 11C detects the voice section. The within-period reaction determination unit 13C according to the embodiment can determine that there is the reaction within the period and can estimate that the user of the terminal 40C is interested in the surrounding sound in a case in which at least one condition of five conditions expressed in formulae (6) to (10) below is satisfied and the satisfied state continues for a predetermined time or more. In formulae (6) to (10), tos indicates a start time of the surrounding voice section, toe indicates an end time of the surrounding voice section, tus indicates a start time of the user voice section, and DT indicates a predetermined time, as described above. Further, th indicates a head reaction, te indicates a visual line reaction, tm indicates a movement reaction, and ti indicates a keyboard reaction.

$$(toe + DT) > tus \text{ and } tos < tus \qquad (6)$$

$$(toe + DT) > th \text{ and } tos < th \qquad (7)$$

$$(toe + DT) > te \text{ and } tos < te \qquad (8)$$

$$(toe + DT) > tm \text{ and } tos < tm \qquad (9)$$

$$(toe + DT) > ti \text{ and } tos < ti \qquad (10)$$

That is, formula (6) expresses that the start time tus of the user voice section is present in a period (reaction determination period) from the start time tos of the surrounding voice section to a time obtained by adding the predetermined time DT to the end time toe of the surrounding voice section. Similarly, formula (7) expresses that the head reaction is performed in the reaction determination period and formula (8) expresses that the visual line reaction is performed in the reaction determination period. Further, formula (9) expresses that the movement reaction is performed in the reaction determination period and formula (10) expresses that the keyboard reaction is performed in the reaction determination period.

Here, in the embodiment, as described above, a plurality of surrounding voice sections are detected to correspond to the plurality of mic elements in a state in which a partial period or all the period overlaps in some cases. In this case, in the embodiment, for example, a period from the earliest time among the start times tos of the plurality of surrounding voice sections to a time obtained by adding the predetermined time DT to the latest time among the end times toe of the plurality of surrounding voice sections is applied as the reaction determination period. However, the disclosure is not limited to this form. For example, the reaction determination period may be derived according to each of the plurality of surrounding voice sections. In this case, in a case in which at least one of the conditions expressed in formulae (6) to (10) is satisfied for at least one period among the reaction determination periods, for example, the form in which the user of the terminal 40C can be estimated to be interested in the surrounding sound by determining that there is the reaction within the period.

On the other hand, the reproduction control unit 14C corresponds to the reproduction control unit 14 described above and performs control such that reproduction of content is restricted in the case in which the within-period reaction determination unit 13C determines that there is the reaction within the period. The reproduction control unit 14C according to the embodiment performs control such that the reproduction volume of the sound content is reduced in the case in which the within-period reaction determination unit 13C determines that there is the reaction within the period, that is, the user can be estimated to be interested in the surrounding sound. In other cases, the reproduction control unit 14C performs control such the reproduction volume of the sound content is set to a normal volume.

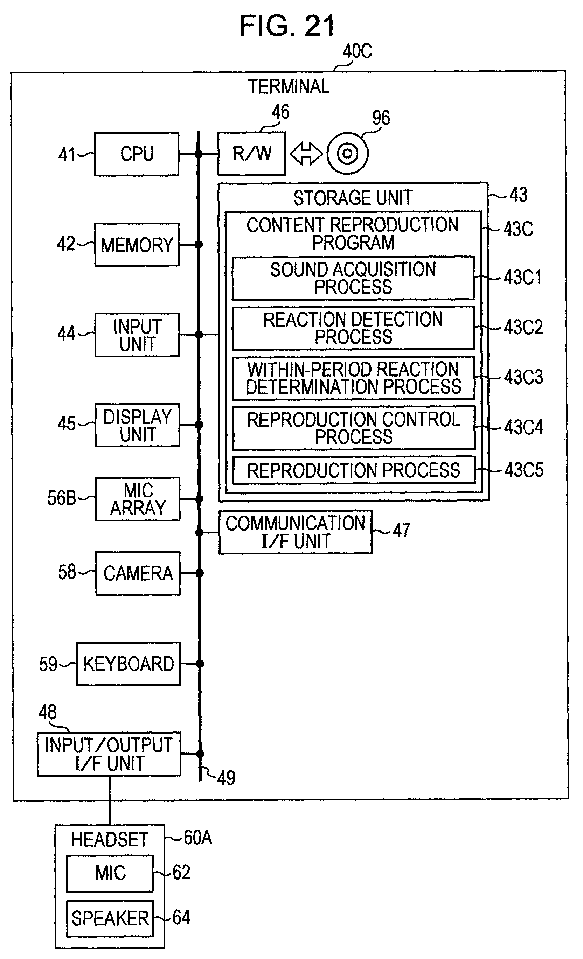

The above-described terminal 40C can be realized by a terminal 40C illustrated in FIG. 21. The same reference numerals as those of FIG. 16 are given to the same constituent elements in FIG. 21 as those of FIG. 16, and the description thereof will be omitted as much as possible.

As illustrated in FIG. 21, in the terminal 40C according to the embodiment, a mic array 56B is connected to a bus 49 instead of the mic 56A and the camera 58 and a keyboard 59 are connected. In the storage unit 43 of the terminal 40C according to the embodiment, the content reproduction program 43C causing the terminal 40C to function as the terminal 40C illustrated in FIG. 20 is stored instead of the content reproduction program 43B. The content reproduction program 43C is stored in the storage unit 43 when the recording medium 96 on which the content reproduction program 43C is written is set in the medium reading/writing device 46 and the medium reading/writing device 46 reads the content reproduction program 43C from the recording medium 96. The CPU 41 reads the content reproduction program 43C from the storage unit 43 and loads the content reproduction program 43C on the memory 42, and then sequentially executes processes included in the content reproduction program 43C.

The content reproduction program 43C includes a sound acquisition process 43C1, an reaction detection process 43C2, a within-period reaction determination process 43C3, a reproduction control process 43C4, and a reproduction process 43C5. The CPU 41 operates as the sound acquisition unit 11C illustrated in FIG. 20 by executing the sound acquisition process 43C1. The CPU 41 operates as the reaction detection unit 12C illustrated in FIG. 20 by executing the reaction detection process 43C2. The CPU 41 operates as the within-period reaction determination unit 13C illustrated in FIG. 20 by executing the within-period reaction determination process 43C3. The CPU 41 operates as the reproduction control unit 14C illustrated in FIG. 20 by executing the reproduction control process 43C4. The CPU 41 operates as the reproduction unit 54 illustrated in FIG. 20 by executing the reproduction process 43C5.

As described above, the terminal 40C executing the content reproduction program 43C functions as the terminal 40C illustrated in FIG. 20. The content reproduction program 43C is an example of the content reproduction program according to the technology of the present disclosure.

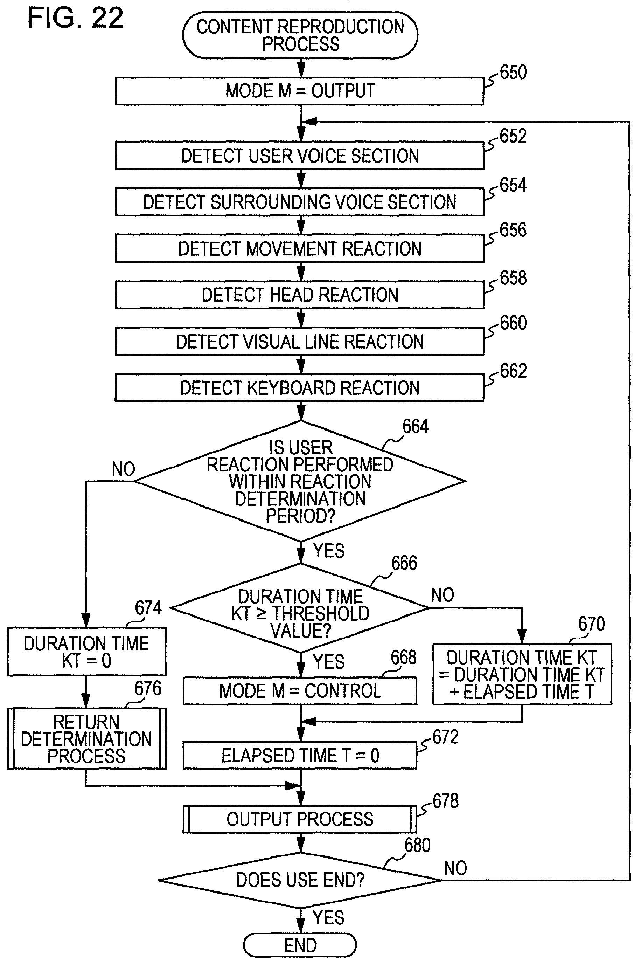

Next, operational effects of the embodiment will be described. Hereinafter, a case will be assumed in which sound content is reproduced using the terminal 40C in a state in which the user of the terminal 40C wears the headset 60A connected to the terminal 40C. In this case, the user of the terminal 40C performs the content reproduction process illustrated in FIG. 22 by causing the terminal 40C to execute the content reproduction program 43C. Hereinafter, to avoid complication, a case will be described in which sound data indicating sound content desired to be reproduced with the terminal 40C by the user of the terminal 40C is stored in the storage unit 43 in advance.

In step 650 of the content reproduction process, the reproduction control unit 14C sets a value indicating "output" representing reproduction of content as a default value in the variable M which is a variable for setting a content reproduction mode.

In subsequent step 652, the reaction detection unit 12C attempts to detect the user voice section from the user sound data. In subsequent step 654, the sound acquisition unit 11C attempts to detect the surrounding voice section from the surrounding sound data. In subsequent step 656, the reaction detection unit 12C attempts to detect the above-described movement reaction by the user of the terminal 40C. In subsequent step 658, the reaction detection unit 12C attempts to detect the above-described head reaction of the user of the terminal 40C. In subsequent step 660, the reaction detection unit 12C attempts to detect the above-described visual line reaction by the user of the terminal 40C. In subsequent step 662, the reaction detection unit 12C attempts to detect the above-described keyboard reaction by the user of the terminal 40C.

In subsequent step 664, the within-period reaction determination unit 13C determines whether the user of the terminal 40C performs the reaction to the surrounding sound within the reaction determination period by determining whether at least one condition of five conditions expressed in formulae (6) to (10) below is satisfied. Here, in a case in which the determination is positive, the process proceeds to step 666.

In step 666, the within-period reaction determination unit 13C determines whether a value of a variable KT, which is a variable indicating a duration time of the condition determined to be satisfied in the process of step 664, is equal to or greater than a predetermined threshold value. In a case in which the determination is positive, the process proceeds to step 668. In step 668, the reproduction control unit 14C sets a value indicating "control" representing that a reproduction state of the content is controlled in the variable M and subsequently the process proceeds to step 672. Conversely, in a case in which the determination is negative in step 666, the process proceeds to step 670. Then, the within-period reaction determination unit 13C updates the variable KT by adding the value of the variable T indicating the elapsed time to the value of the variable KT and subsequently the process proceeds to step 672.

In step 672, the reproduction control unit 14C clears the variable T (sets 0 (zero) in the embodiment) and subsequently the process proceeds to step 678.

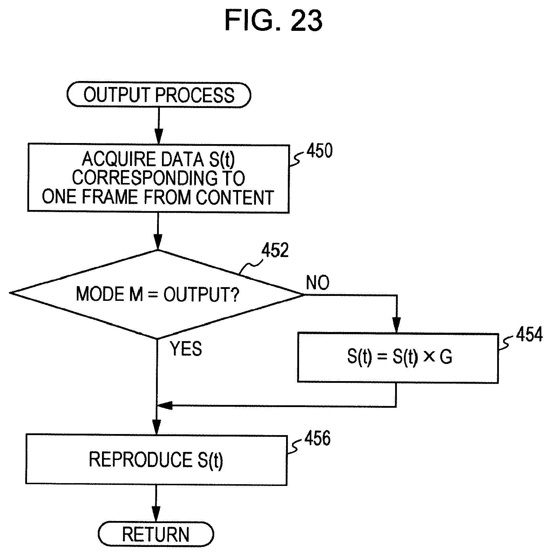

Conversely, in a case in which the determination is negative in step 664, the process proceeds to step 674. The within-period reaction determination unit 13C clears the variable KT and subsequently the process proceeds to step 676. The reproduction control unit 14C performs the returns determination process illustrated in FIG. 18 and subsequently the process proceeds to step 678. In step 678, the reproduction control unit 14C performs the output process illustrated in FIG. 23.

In step 450 of the output process, the reproduction control unit 14C reads sound data S(t) corresponding to one frame from the sound content stored in the storage unit 43. In subsequent step 452, the reproduction control unit 14C determines whether the value indicating "output" described above is set in the variable M. In a case in which the determination is positive, the process proceeds to step 456 to be described below. Conversely, in a case in which the determination is negative, the process proceeds to step 454.

In step 454, the reproduction control unit 14C performs conversion on the sound data S(t) in accordance with formula (11) below to decrease the volume of the sound reproduced by the sound data S(t) and subsequently the process proceeds to step 456. G in formula (11) is a variable indicating a ratio of a decrease of the volume. In the embodiment, G is set in advance as a value (0.5 in the embodiment) within a range equal to or greater than 0 (zero) and less than 1.

$$S(t) = S(t) \times G \qquad (11)$$

In step 456, the reproduction unit 54 reproduces the sound indicated by the sound data by transmitting the sound data S(t) to the speaker 64 of the headset 60A and subsequently the output process ends. When the output process ends, the process proceeds to step 680 of the content reproduction process illustrated in FIG. 22.

In subsequent step 680, the reproduction unit 54 determines whether the use of the terminal 40C by the user ends. In a case in which the determination is negative, the process returns to step 652. At a time point at which the determination is positive, the content reproduction process ends.

In the embodiment, whether the use of the terminal 40C ends is determined in step 680 by determining whether the reproduction of all the sound data stored in the storage unit 43 ends. However, the disclosure is not limited thereto. For example, whether the use of the terminal 40C ends may be determined by determining whether an instruction given by the user to end the use of the content reproduction process is input via the input unit 44. For example, whether the use of the terminal 40C ends may be determined, for example, by determining whether a power switch of the terminal 40C is considered to be turned off.

As described in detailed above, in the embodiment, it is possible to obtain the same advantages as those of the second embodiment and obtain the following advantages.

That is, in the embodiment, the reaction detection unit 12 detects a motion of the head of the user as the reaction. Accordingly, even in a state in which the user does not utter, the control can be performed such that the reproduction of the content is restricted according to the motion of the head of the user.

In the embodiment, the reaction detection unit 12 detects a change in the input frequency to the keyboard by the user as the reaction. Accordingly, even in a state in which the user does not utter, the control can be performed such that the reproduction of the content is restricted according to the change in the input frequency to the keyboard by the user.

In the embodiment, the reaction detection unit 12 detects a user movement reaction as the reaction. Accordingly, even in a state in which the user does not utter, the control can be performed such that the reproduction of the content is restricted according to a user movement reaction.

In the embodiment, the reaction detection unit 12 detects a motion of a visual line of the user as the reaction. Accordingly, even in a state in which the user does not utter, the control can be performed such that the reproduction of the content is restricted according to the motion of the visual line of the user.

In the embodiment, the reproduction control unit 14 performs the control such that the reproduction volume of the content is reduced in the case in which the within-period reaction determination unit 13 determines that there is the reaction within the period, that is, in the case in which the user can be estimated to be interested in the surrounding sound. In the embodiment, the control is performed such that the reproduction volume of the content is returned to the original volume in the case in which the control is performed such that the reproduction volume of the content is reduced and in the case in which the within-period reaction determination unit 13 determines that there is no reaction within the period, that is, the user can be estimated not to be interested in the surrounding sound. Accordingly, even in a case in which the user is estimated to be interested in the surrounding sound, the volume can be reduced and the reproduction of the content can continue. Therefore, it is possible to further improve convenience for the user.

In the embodiment, the reaction detection unit 12 detects a rotation reaction in the horizontal direction of the head as a motion of the head of the user. Accordingly, it is possible to detect the look-back reaction of the user as the reaction.

In the embodiment, the reaction detection unit 12 detects a rotation reaction in the horizontal direction of the head with respect to the direction of a source generating the surrounding sound. Accordingly, it is possible to detect the reaction to the surrounding sound by the user with higher precision.

In the embodiment, the reaction detection unit 12 detects vibration of the head as a motion of the head of the user. Accordingly, it is possible to detect the nod reaction of the user as the reaction.

In the embodiment, the reaction detection unit 12 detects an reaction of reducing the input frequency by a predetermined amount or more as a change in the input frequency to the keyboard. Accordingly, it is possible to detect the reaction to the surrounding sound by the user with high precision.

In the embodiment, the reaction detection unit 12 detects a motion of a visual line with respect to the direction of a source generating the surrounding sound. Accordingly, it is possible to detect the reaction to the surrounding sound by the user with high precision.

Further, in the embodiment, the user is estimated to be interested in the surrounding sound in the case in which the reaction is detected for a predetermined period or more within the period (the reaction determination period) in which the time point at which the voice section of the acquired surrounding sound starts is set as a starting point and the time point at which the voice section ends and the predetermined time passes is set as an ending point. Accordingly, it is possible to estimate whether the user is interested in the surrounding sound with higher precision.

(Fourth Embodiment)

In a fourth embodiment, a case in which the content reproduction device 10 is applied to a glasses type wearable terminal (hereinafter simply referred to as a "terminal") including a mic, a mic array, a motion detection sensor, a speaker, and a display will be described.

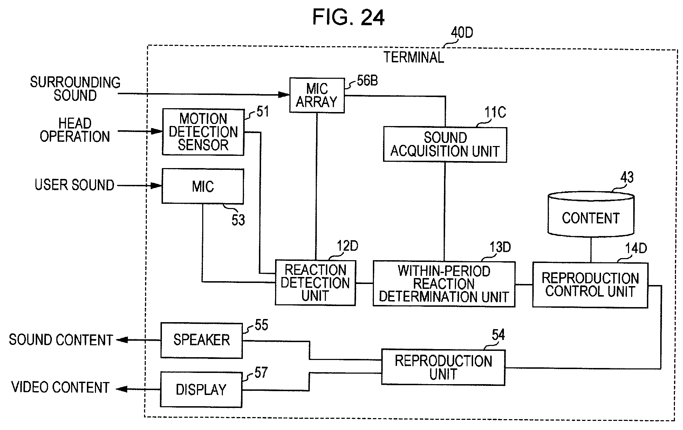

FIG. 24 illustrates a terminal 40D according to the embodiment. The same reference numerals as those of FIG. 20 are given to the same constituent elements in FIG. 24 as those of FIG. 20, and the description thereof will be omitted as much as possible.

As illustrated in FIG. 24, the terminal 40D according to the embodiment is different from the terminal 40C according to the third embodiment in that a motion detection sensor 51, a mic 53, a speaker 55, and a display 57 are newly provided. The terminal 40D according to the embodiment is different from the terminal 40C according to the third embodiment in that the camera 58, the keyboard 59, the reception unit 50A, and the transmission unit 50C are not provided.

The terminal 40D according to the embodiment is different from the terminal 40C according to the third embodiment in that the reaction detection unit 12C is configured as an reaction detection unit 12D performing a different process from the reaction detection unit 12C. The terminal 40D according to the embodiment is different from the terminal 40C according to the third embodiment in that the within-period reaction determination unit 13C is configured as a within-period reaction determination unit 13D performing a different process from the within-period reaction determination unit 13C. The terminal 40D according to the embodiment is different from the terminal 40C according to the third embodiment in that the reproduction control unit 14C is configured as a reproduction control unit 14D performing a different process from the reproduction control unit 14C.

Further, The terminal 40D according to the embodiment is different from the terminal 40C according to the third embodiment in that content stored in the storage unit 43 is content indicating a moving image with a sound (hereinafter referred to as "video content"). In the embodiment, the headset 60A is not used.

The motion detection sensor 51 is a sensor that detects a motion of the terminal 40D. In the embodiment, a gyro sensor is applied, but the disclosure is not limited thereto. For example, another sensor capable of detecting a motion of the terminal 40D, such as a tri-axial acceleration sensor or an electronic compass, may be applied.

The mic 53 collects an utterance by the user of the terminal 40D and is provided in the terminal 40D to be close to the mouth of the user when the user of the terminal 40D wears the terminal 40D. In the embodiment, a directional mic collecting a sound arrived in the direction of the mouth of the user with high precision is used as the mic 53, but the disclosure is not limited thereto. According to distances between the user of the terminal 40D and other user, the number of other users, or the like, a non-directional mic may be used as the mic 53. The speaker 55 is provided in the terminal 40D to be close to an ear of the user when the user of the terminal 40D wears the terminal 40D. Further, the display 57 includes a video projection unit provided on one side surface of the terminal 40D so that a video is projected to a part of a lens on the one side surface, but a display form of a video is not limited to such a projection scheme.

On the other hand, the reaction detection unit 12D corresponds to the reaction detection unit 12 described above and acquires a signal indicating a motion state of the terminal 40D obtained by the motion detection sensor 51 (hereinafter referred to as a "motion state signal) and the sound data (user sound data) obtained by the mic 53. The reaction detection unit 12D acquires sound data (surrounding sound data) obtained by the mic array 56B. Then, the reaction detection unit 12D detects a reaction to the surrounding sound of the user of the terminal 40D based on the motion state signal, the user sound data, and the surrounding sound data.

The reaction detection unit 12D according to the embodiment learns (stores), as sound data indicating background noise, the sound data obtained by the mics 53 in advance in a state in which the user of the terminal 40D or other users do not perform an reaction of speaking sounds such as conversation or a sound of movement. Then, the reaction detection unit 12D detects a section in which the SNR, which is a ratio of the sound data obtained by the mic 53 to the sound data indicating the noise, is equal to or greater than a predetermined threshold value as a voice section (a user voice section) by an utterance of the user of the terminal 40D.

As in the reaction detection unit 12C according to the third embodiment, the reaction detection unit 12D estimates a direction oa(t) of a sound source around the terminal 40D based on a plurality of pieces of surrounding sound data obtained by the mic array 56B.

The reaction detection unit 12D detects an reaction of the head of the user as follows based on the estimated direction oa(t) of the sound source and the motion state signal.

That is, the reaction detection unit 12D sets an angular velocity in the horizontal direction obtained by the motion state signal from the motion detection sensor 51 at a time point of time t as vh(t) and sets an angular velocity in the vertical direction as w(t). For the angle in the horizontal direction, a clockwise direction is in the range of +1 degree to +179 degrees, a counterclockwise direction is in the range of -1 degree to -179 degrees, and a rear direction is ±180 degrees. For the angle in the vertical direction, an upper side is in the range of +1 degree to +90 degrees and a lower side is in the range of -1 degree to -90 degrees.

Next, the reaction detection unit 12D determines that the head of the user performs an reaction (head reaction) as a reaction of the user of the terminal 40D to a surrounding sound in a case in which formulae (12) to (15) below satisfy at least one of the following conditions.

$$(oa(t-a)+TH\_RT1) > \sum_{i=t-a}^{i=t} vh(i) > (oa(t-a)-TH\_RT1), a < DH1 \qquad (1\ 2)$$

$$-\sum_{i=t-b-c}^{i=t-b} vv(i) > TH\_RT2$$

and

$$\sum_{i=t-b}^{i=t} vv(i) > TH\_RT2, b < DH2, c < DH2 \qquad (1\ 3)$$

$$-\sum_{i=t-b-c}^{i=t-b} vh(i) > TH\_RT2$$

and

$$\sum_{i=t-b}^{i=t} vh(i) > TH\_RT2, b < DH2, c < DH2 \qquad (1\ 4)$$

$$\sum_{i=t-b-c}^{i=t-b} vh(i) > TH\_RT2$$

and

$$-\sum_{i=t-b}^{i=t} vh(i) > TH\_RT2, b < DH2, c < DH2 \qquad (1\ 5)$$

Formula (12) indicates a condition in a case in which the head of the user performs an reaction (look-back reaction) of orienting in the direction (oa(t - a)) of the sound source within a range defined by a threshold value TH_RT1 within a given time DH1. Formula (13) indicates a condition in a case in which the head of the user performs an reaction (node reaction) of orienting in the lower direction beyond an angle defined by the threshold value TH_RT2 within the given time DH2 and subsequently orienting in the upper direction beyond the angle within the given time DH2. Formulae (14) and (15) indicate a condition in a case in which the head of the user performs an reaction (swing reaction) of orienting in one of the right and left directions beyond an angle defined by the threshold value TH_RT2 within the given time DH2 and subsequently orienting the other of the right and left directions beyond the angle within the given time DH2.

The reaction detection unit 12D detects a walking reaction of the user based on the motion state signal in accordance with a known technology of related art (for example, the same technology as a pedometer (registered trademark)). Then, in a case in which the reaction detection unit 12D detect a predetermined number of steps (5 steps in the embodiment) or more, the reaction detection unit 12D determines that the user performs a movement reaction (movement reaction) as a reaction of the user of the terminal 40D to the surrounding sound.

In the embodiment, the threshold value used when the surrounding voice section is detected in the sound acquisition unit 11C is also set to be the same as the threshold value used when the user voice section is detected in the reaction detection unit 12D, but the disclosure is not limited thereto. The threshold values may be different from each other according to a difference in the sound collection characteristics between the mic array 56B and the mic 53, distances between the user of the terminal 40D and the other users, or the number of other users.

On the other hand, the within-period reaction determination unit 13D corresponds to the within-period reaction determination unit 13 described above and determines whether there is the reaction within the period or there is no reaction within the period based on whether the reaction detection unit 12D detects the reaction at a predetermined frequency within a predetermined period from the voice section detected by the sound acquisition unit 11C. The within-period reaction determination unit 13D according to the embodiment can estimate that the user of the terminal 40D is interested in the surrounding sound in a case in which at least one condition of three conditions expressed in formulae (16) to (18) below is satisfied and the satisfied state continues for a predetermined number of times or more. In formulae (16) to (18), tos indicates a start time of the surrounding voice section, toe indicates an end time of the surrounding voice section, tus indicates a start time of the user voice section, and DT indicates a predetermined time, as described above. Further, th indicates a head reaction and tm indicates a movement reaction.

$$(toe + DT) > tus \ \ and \ \ tos < tus \qquad (16)$$

$$(toe + DT) > th \ \ and \ \ tos < th \qquad (17)$$

$$(toe + DT) > tm \ and \ tos < tm \qquad (18)$$

That is, formula (16) expresses that the start time tus of the user voice section is present in a period (reaction determination period) from the start time tos of the surrounding voice section to a time obtained by adding the predetermined time DT to the end time toe of the surrounding voice section. Similarly, formula (17) expresses that the head reaction is performed in the reaction determination period and formula (18) expresses that the movement reaction is performed in the reaction determination period.

On the other hand, the reproduction control unit 14D corresponds to the reproduction control unit 14 described above and performs control such that reproduction of content is restricted in the case in which the within-period reaction determination unit 13D determines that there is the reaction within the period. The reproduction control unit 14D according to the embodiment performs control such that the reproduction speed of the video content is reduced in the case in which the within-period reaction determination unit 13D determines that there is the reaction within the period, that is, the user can be estimated to be interested in the surrounding sound. In other cases, the reproduction control unit 14D performs control such the reproduction speed of the video content is set to a normal speed.

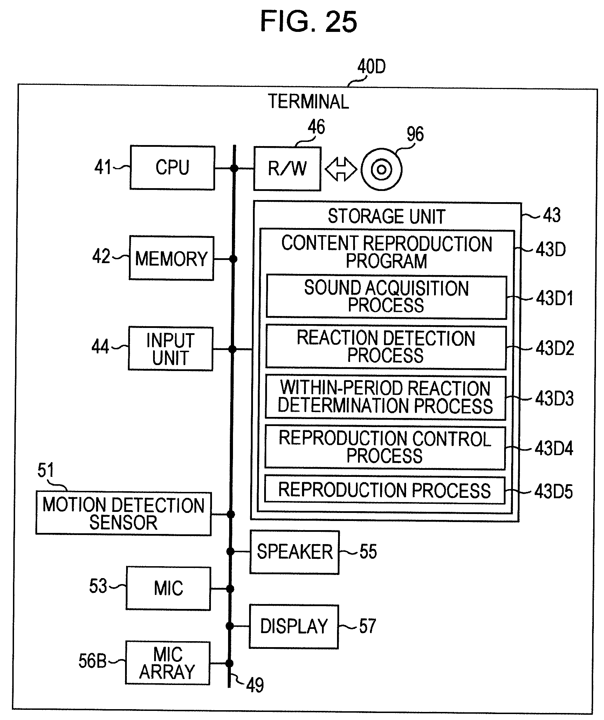

The above-described terminal 40D can be realized by a terminal 40D illustrated in FIG. 25. The same reference numerals as those of FIG. 21 are given to the same constituent elements in FIG. 25 as those of FIG. 21, and the description thereof will be omitted as much as possible.

As illustrated in FIG. 25, in the terminal 40D according to the embodiment, the display 57 is connected to the bus 49 instead of the display unit 45 and the motion detection sensor 51, a mic 53, and a speaker 55 are connected. In the storage unit 43 of the terminal 40D according to the embodiment, a content reproduction program 43D causing the terminal 40D to function as the terminal 40D illustrated in FIG. 24 is stored instead of the content reproduction program 43C. The content reproduction program 43D is stored in the storage unit 43 when the recording medium 96 on which the content reproduction program 43D is written is set in the medium reading/writing device 46 and the medium reading/writing device 46 reads the content reproduction program 43D from the recording medium 96. The CPU 41 reads the content reproduction program 43D from the storage unit 43 and loads the content reproduction program 43D on the memory 42, and then sequentially executes processes included in the content reproduction program 43D.

The content reproduction program 43D includes a sound acquisition process 43D1, an reaction detection process 43D2, a within-period reaction determination process 43D3, a reproduction control process 43D4, and a reproduction process 43D5. The CPU 41 operates as the sound acquisition unit 11C illustrated in FIG. 24 by executing the sound acquisition process 43D1. The CPU 41 operates as the reaction detection unit 12D illustrated in FIG. 24 by executing the reaction detection process 43D2. The CPU 41 operates as the within-period reaction determination unit 13D illustrated in FIG. 24 by executing the within-period reaction determination process 43D3. The CPU 41 operates as the reproduction control unit 14D illustrated in FIG. 24 by executing the reproduction control process 43D4. The CPU 41 operates as the reproduction unit 54 illustrated in FIG. 24 by executing the reproduction process 43D5.

As described above, the terminal 40D executing the content reproduction program 43D functions as the terminal 40D illustrated in FIG. 24. The content reproduction program 43D is an example of the content reproduction program according to the technology of the present disclosure.

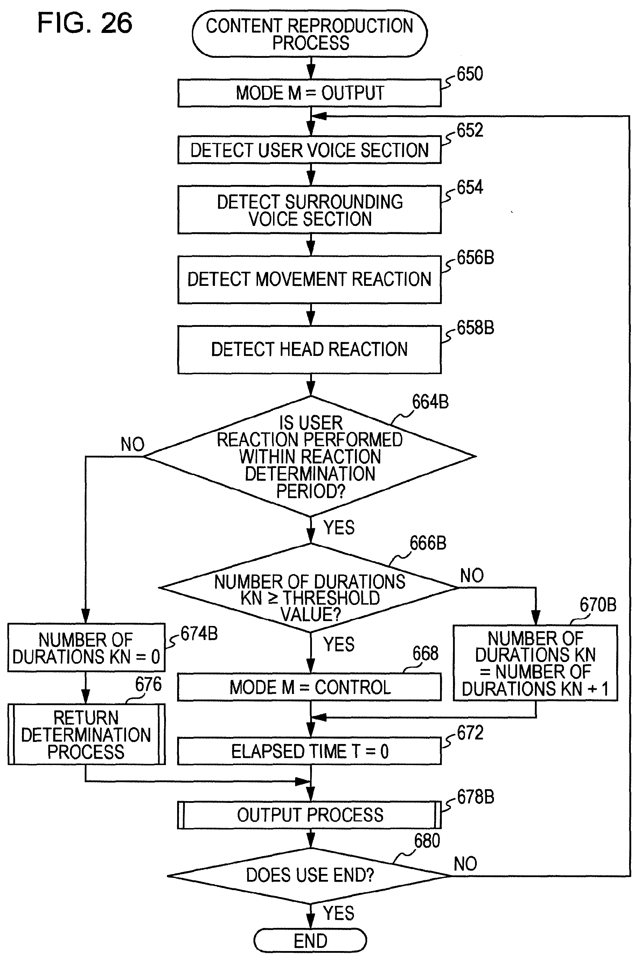

Next, operational effects of the embodiment will be described. Hereinafter, a case will be assumed in which video content is reproduced using the terminal 40D in a state in which the user of the terminal 40D wears the terminal 40D. In this case, the user of the terminal 40D performs the content reproduction process illustrated in FIG. 26 by executing the content reproduction program 43D with the terminal 40D. Hereinafter, to avoid complication, a case will be described in which video data including sound data and moving-image data indicating video content desired to be reproduced with the terminal 40D by the user of the terminal 40D is stored in the storage unit 43 in advance. The same reference numerals as those of FIG. 22 are given to the same constituent elements in FIG. 26 as those of FIG. 22, and the description thereof will be omitted as much as possible.

In subsequent step 656B of the content reproduction process, the reaction detection unit 12D attempts to detect the above-described movement reaction by the user of the terminal 40D. In subsequent step 658B, the reaction detection unit 12D attempts to detect the above-described head reaction of the user of the terminal 40D.

In subsequent step 664B, the within-period reaction determination unit 13D determines whether the user of the terminal 40D performs the reaction to the surrounding sound within the reaction determination period by determining whether at least one condition of three conditions expressed in formulae (16) to (18) below is satisfied. Here, in a case in which the determination is positive, the process proceeds to step 666B.

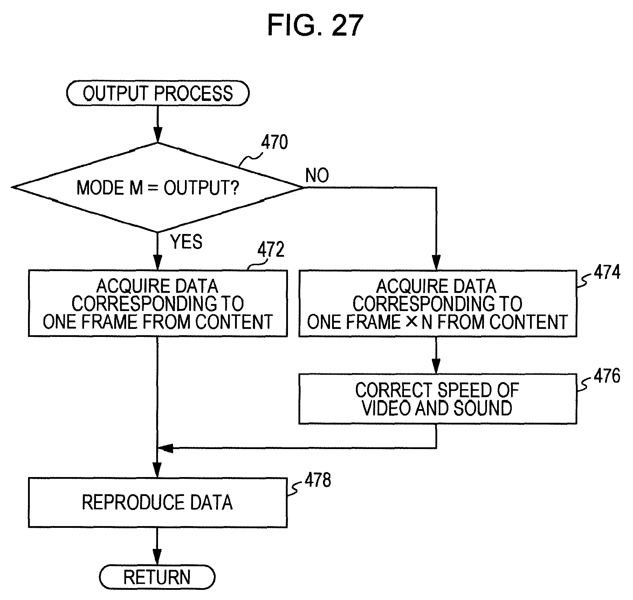

In step 666B, the within-period reaction determination unit 13D determines whether a value of a variable KN, which is a variable indicating the number of durations of the condition determined to be satisfied in the process of step 664B, is equal to or greater than a predetermined threshold value. In a case in which the determination is positive, the process proceeds to step 668. Conversely, in a case in which the determination is negative in step 666B, the process proceeds to step 670B and the within-period reaction determination unit 13D updates the value of the variable KN by increasing the value of the variable KN by one. Thereafter, the process proceeds to step 672. Conversely, in a case in which the determination is negative in step 664B, the process proceeds to step 674B. The within-period reaction determination unit 13D clears the variable KN and subsequently the process proceeds to step 676. Thereafter, in step 678B, the reproduction control unit 14D performs the output process illustrated in FIG. 27.

In step 470 of the output process, the reproduction control unit 14D determines whether the value indicating "output" described above is set in the variable M. In a case in which the determination is positive, the process proceeds to step 472. In step 472, the reproduction control unit 14D reads the moving-image data and the sound data corresponding to one frame from the video content stored in the storage unit 43. Thereafter, the process proceeds to step 478.

Conversely, in a case in which the determination is negative in step 470, the process proceeds to step 474 and the reproduction control unit 14D reads the moving-image data and the sound data corresponding to a plurality (N) of frames from the video content stored in the storage unit 43. In subsequent step 476, the reproduction control unit 14D converts (corrects) each piece of data so that the reproduction of the video of the read moving-image data and sound data is reduced by a predetermined ratio (50% in the embodiment) and subsequently the process proceeds to step 478.

In step 478, the reproduction unit 54 reproduces the video content indicated by the sound data and the moving-image data by transmitting the sound data obtained through the foregoing processes to the speaker 55 and transmitting the moving-image data to the display 57, and subsequently the output process ends. When the output process ends, the content reproduction process illustrated in FIG. 26 proceeds to step 680 of the content reproduction process.

As described in detailed above, in the embodiment, it is possible to obtain the same advantages as those of the third embodiment and obtain the following advantages.

In the embodiment, the reproduction control unit 14 performs the control such that the reproduction speed of the content is reduced in the case in which the within-period reaction determination unit 13 determines that there is the reaction within the period, that is, in the case in which the user can be estimated to be interested in the surrounding sound. In the embodiment, the reproduction control unit 14 performs the control such that the reproduction speed of the content is returned to the original speed in the case in which the reproduction control unit 14 performs the control such that the reproduction speed of the content is reduced and in the case in which the within-period reaction determination unit 13 determines that there is no reaction within the period, that is, the user can be estimated not to be interested in the surrounding sound. Accordingly, even in a case in which the user is estimated to be interested in the surrounding sound, the reproduction speed can be reduced and the reproduction of the content can continue. Therefore, it is possible to further improve convenience for the user.

Further, in the embodiment, it is determined that there is the reaction within the period in the case in which the reaction is detected the predetermined number of times per the predetermined period within the period in which the time point at which the pronunciation of the acquired surrounding sound starts is set as a starting point and the time point at which the pronunciation ends and the predetermined time passes is set as an ending point. Accordingly, it is possible to estimate whether the user is interested in the surrounding sound with higher precision.

(Fifth Embodiment)

In a fifth embodiment, a case in which the content reproduction device 10 is applied to a system including a server, a terminal (desktop PC), a headset, and a recorder as in the first embodiment will be described.

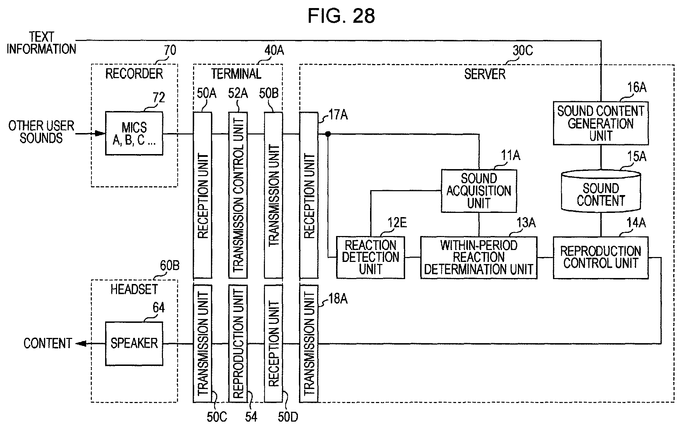

FIG. 28 illustrates a server 30C, a terminal 40A, a headset 60B, and a recorder 70 according to the embodiment. The same reference numerals as those of FIG. 6 are given to the same constituent elements in FIG. 28 as those of FIG. 6, and the description thereof will be omitted as much as possible.

As illustrated in FIG. 28, the server 30C according to the embodiment is different from the server 30A according to the first embodiment in that the reaction detection unit 12A is configured as an reaction detection unit 12E performing a different process from the reaction detection unit 12A. The headset 60B according to the embodiment is different from the headset 60A according to the first embodiment in that the mic 62 is not provided. Accordingly, the terminal 40A does not receive user sound data from the headset 60B.

The reaction detection unit 12E of the server 30C corresponds to the reaction detection unit 12 described above and acquires the surrounding sound data obtained by any mic 72 (hereinafter referred to as a "specific mic") of the recorder 70 via the terminal 40A. The reaction detection unit 12E detects a reaction to a surrounding sound of the user of the terminal 40A based on the acquired surrounding sound data. In the embodiment, the mic 72 used by another user closest to the user of the terminal 40A is applied as a specific mic, but the disclosure is not limited thereto.

The reaction detection unit 12E according to the embodiment learns (stores), as sound data indicating background noise, the sound data obtained by the specific mic in advance in a state in which the user of the terminal 40A or other users do not perform an reaction of speaking sounds such as conversation or a sound of movement. Further, the reaction detection unit 12E learns (stores) a spectrum feature amount of the surrounding voice section in advance based on the surrounding sound data obtained by the specific mic according to an utterance when only the user of the terminal 40A utters.

On the other hand, the reaction detection unit 12E detects a section in which the SNR, which is a ratio of the sound data obtained by the specific mic to the sound data indicating the noise, is equal to or greater than a predetermined threshold value as a candidate of the user voice section by the utterance of the user of the terminal 40A. Then, the reaction detection unit 12E matches a spectrum feature amount of the candidate of the user voice section to the spectrum feature amount learned in advance. In a case in which the distance is equal to or less than a predetermined threshold value, the user voice section is decided as the user voice section by the user of the terminal 40A. Since a technology for specifying sound data of a specific user from sound data at that time is a known technology of the related described in, for example, Japanese Examined Patent Application Publication No. 01-36960, the further description thereof will be omitted.

In the embodiment, the threshold value used when a candidate of the surrounding voice section is detected in the sound acquisition unit 11A is also set to be the same as the threshold value used when the user voice section is detected in the reaction detection unit 12E, but the disclosure is not limited thereto. The threshold values may be different values according to distance between the user of the terminal 40A and other users, the number of other users, or the like.

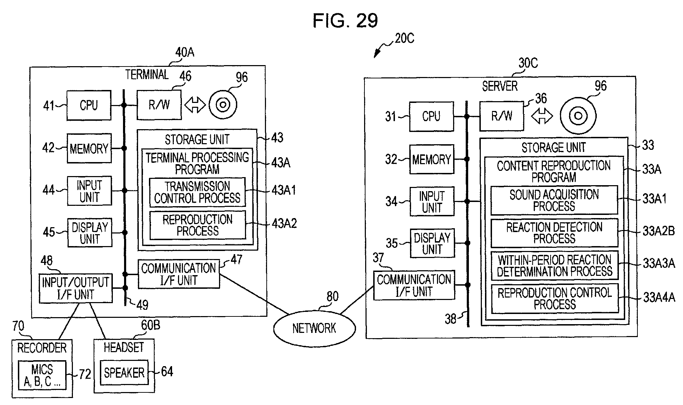

The server 30C and the terminal 40A described above can be respectively realized by the server 30C and the terminal 40A included in a computer system 20C illustrated in FIG. 29. The same reference numerals as those of FIG. 8 are given to the same constituent elements in FIG. 29 as those of FIG. 8, and the description thereof will be omitted as much as possible.

As illustrated in FIG. 29, the server 30C according to the embodiment is different from the server 30A according to the first embodiment only in that the reaction detection process 33A2A in the content reproduction program 33A is configured as an reaction detection process 33A2B.

The CPU 41 operates as the reaction detection unit 12E illustrated in FIG. 28 by executing the reaction detection process 33A2B. Accordingly, the server 30C executing the content reproduction program 33A functions as the server 30C illustrated in FIG. 28.

Next, operational effects of the embodiment will be described. The operational effects of the terminal 40A according to the embodiment are the same as those of the first embodiment, and thus the description thereof will be omitted here. Hereinafter, the operational effects of the server 30C will be described.

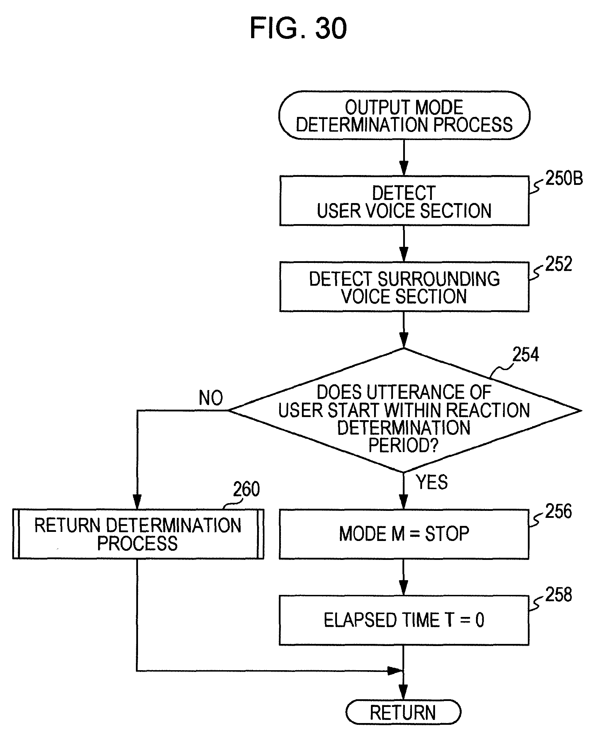

The server 30C performs the content reproduction process illustrated in FIG. 10 by executing the content reproduction program 33A when the access from the terminal 40A starts. However, the content reproduction process executed by the server 30C according to the embodiment is different from that of the first embodiment only in that the output mode determination process executed in the content reproduction process is executed as an output mode determination process illustrated in FIG. 30. Accordingly, only the output mode determination process illustrated in FIG. 30 will be described. The same reference numerals as those of FIG. 11 are given to the same steps of executing the same processes in FIG. 30 as those of FIG. 11, and the description thereof will be omitted as much as possible.

In step 250B of the output mode determination process, the reaction detection unit 12E attempts to detect the user voice section from the surrounding sound data through the matching using the spectrum feature amount based on the utterance of the user of the terminal 40A learned in advance, as described above.

As described in detail above, in the embodiment, it is possible to obtain the same advantages as those of the first embodiment. It is possible to realize the technology of the present disclosure at lower cost as the omission result of the mic 62 correcting the utterance of the user of the terminal 40A.

(Sixth Embodiment)

In a sixth embodiment, a case in which the content reproduction device 10 is applied to a system including a server, a terminal (desktop PC), a headset, and a recorder as in the first embodiment will be described.

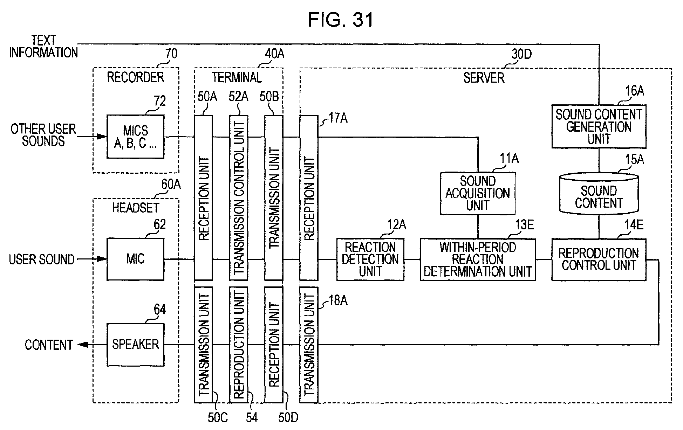

FIG. 31 illustrates a server 30D, a terminal 40A, a headset 60A, and a recorder 70 according to the embodiment. The same reference numerals as those of FIG. 6 are given to the same constituent elements in FIG. 31 as those of FIG. 6, and the description thereof will be omitted as much as possible.

As illustrated in FIG. 31, the server 30D according to the embodiment is different from the server 30A according to the first embodiment in that the within-period reaction determination unit 13A is configured as a within-period reaction determination unit 13E performing a different process from the within-period reaction determination unit 13A. The server 30D according to the embodiment is different from the server 30A according to the first embodiment in that the reproduction control unit 14A is configured as a reproduction control unit 14E performing a different process form the reproduction control unit 14A.

The within-period reaction determination unit 13E of the server 30D corresponds to the within-period reaction determination unit 13 described above and determines whether there is the reaction within the period or there is no reaction within the period based on whether the reaction detection unit 12A detects the reaction at a predetermined frequency within a predetermined period from the voice section detected by the sound acquisition unit 11A. In a case in which a predetermined number of times (hereinafter referred to as a "reaction frequency") per a predetermined period of the reaction detected by the reaction detection unit 12A within the reaction determination period exceeds the threshold value TH2, the within-period reaction determination unit 13E determines that there is the reaction within the period. In a case in which the within-period reaction determination unit 13E determines that there is the reaction within the period and subsequently the reaction frequency is equal to or less than the threshold value TH2, the within-period reaction determination unit 13E determines that there is no reaction within the period.

In the within-period reaction determination unit 13E according to the embodiment, a reaction frequency rate[t] at time t is calculated by formula (19) below. In formula (19), vad[t] indicates a determination result obtained by determining whether the reaction is detected at time t. In the embodiment, in a case in which the reaction is detected, '1' is substituted. In a case in which the reaction is not detected, '0' is substituted. In formula (19), L indicates the number of frames (50 frames in the embodiment) going back to the past as a calculation target of the reaction frequency.

$$rate[t] = \frac{\sum_{i=0}^{L-1} vad[t-i]}{L} \qquad (19)$$

On the other hand, the reproduction control unit 14E corresponds to the reproduction control unit 14 described above and performs control such that reproduction of content is restricted in a case in which the within-period reaction determination unit 13E determines that there is the reaction within the period. The reproduction control unit 14E according to the embodiment performs control such that the reproduction of the sound content is stopped in the case in which the within-period reaction determination unit 13E determines that there is the reaction within the period, and the reproduction of the sound content is continued in other cases.

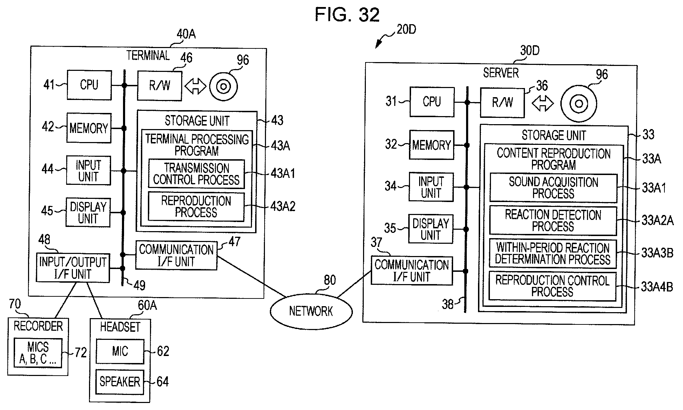

The server 30D and the terminal 40A described above can be respectively realized by a server 30D and a terminal 40A included in a computer system 20D illustrated in FIG. 32. The same reference numerals as those of FIG. 8 are given to the same constituent elements in FIG. 32 as those of FIG. 8, and the description thereof will be omitted as much as possible.

As illustrated in FIG. 32, the server 30D according to the embodiment is different from the server 30A according to the first embodiment in that the within-period reaction determination process 33A3A in the content reproduction program 33A is configured as a within-period reaction determination process 33A3B. The server 30D according to the embodiment is different from the server 30A according to the first embodiment in that the reproduction control process 33A4A in the content reproduction program 33A is configured as a reproduction control process 33A4B.

The CPU 31 operates the within-period reaction determination unit 13E illustrated in FIG. 31 by executing the within-period reaction determination process 33A3B and operates as the reproduction control unit 14E illustrated in FIG. 31 by executing the reproduction control process 33A4B. Accordingly, the server 30D executing the content reproduction program 33A functions as the server 30D illustrated in FIG. 31.

Next, operational effects of the embodiment will be described. The operational effects of the terminal 40A according to the embodiment are the same as those of the first embodiment, and thus the description thereof will be omitted here. Hereinafter, the operational effects of the server 30D will be described.

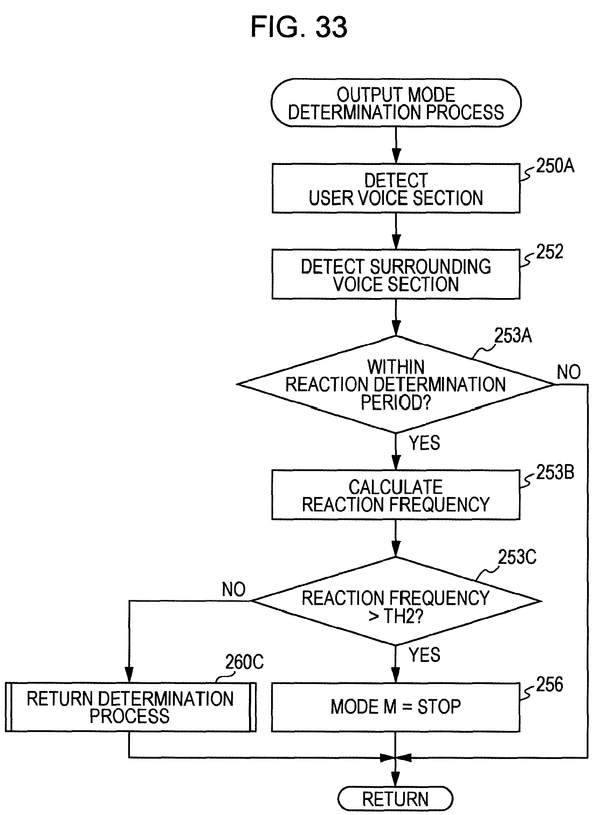

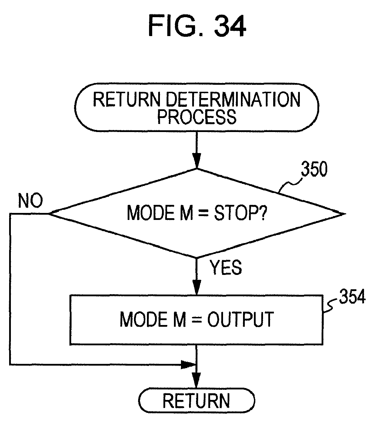

The server 30D performs the content reproduction process illustrated in FIG. 10 by executing the content reproduction program 33A when the access from the terminal 40A starts. However, the content reproduction process executed by the server 30D according to the embodiment is different from that of the first embodiment in that the output mode determination process executed in the content reproduction process is executed as an output mode determination process illustrated in FIG. 33. The output mode determination process executed by the server 30D according to the embodiment is different from that of the first embodiment in that the return determination process executed in the output mode determination process is configured as a return determination process illustrated in FIG. 34.

Accordingly, only the output mode determination process and the return determination process according to the embodiment will be described below. The same reference numerals as those of FIG. 11 are given to the same steps of executing the same processes in FIG. 33 as those of FIG. 11, and the description thereof will be omitted as much as possible. The same reference numerals as those of FIG. 12 are given to the same steps of executing the same processes in FIG. 34 as those of FIG. 12, and the description thereof will be omitted as much as possible.

In step 253A of the output mode determination process, the within-period reaction determination unit 13E determines whether this time point is within the reaction determination period. In a case in which the determination is negative, the output mode determination process ends. Conversely, in a case in which the determination is positive, the process proceeds to step 253B.

In step 253B, the within-period reaction determination unit 13E calculates the reaction frequency rate[t] by formula (19) described above. In subsequent step 253C, the within-period reaction determination unit 13E determines whether the reaction frequency rate[t] exceeds the predetermined threshold value TH2. In a case in which the determination is positive, the process proceeds to step 256. Conversely, in a case in which the determination is negative, the process proceeds to step 260C.

In step 260C, the reproduction control unit 14E performs a return determination process illustrated in FIG. 34. The return determination process according to the embodiment is different from the return determination process according to the first embodiment illustrated in FIG. 12 only in that the processes of steps 352 and 356 are deleted. Therefore the description thereof will be omitted here.

As described in detail above, in the embodiment, it is possible to obtain the same advantages as those of the first embodiment and to obtain the following advantage.

That is, in the embodiment, when the within-period reaction determination unit 13 determines that there is the reaction within the period and subsequently the reaction frequency becomes equal to or less than the threshold value TH2 within the reaction determination period, the within-period reaction determination unit 13 determines that there is no reaction within the period. Therefore, in the embodiment, the content can be reproduced in a more appropriate state than in a technology in which the reaction frequency is not used.

(Seventh Embodiment)

In a seventh embodiment, a case in which the content reproduction device 10 is applied to a system including a server, a terminal (desktop PC), a headset, and a recorder as in the first embodiment will be described.

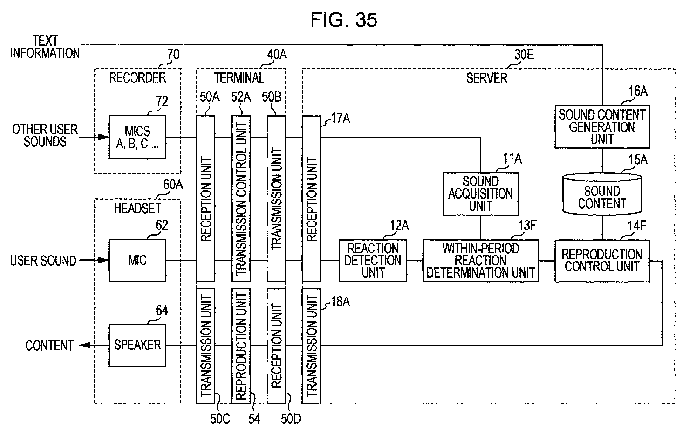

FIG. 35 illustrates a server 30E, a terminal 40A, a headset 60A, and a recorder 70 according to the embodiment. The same reference numerals as those of FIG. 6 are given to the same constituent elements in FIG. 35 as those of FIG. 6, and the description thereof will be omitted as much as possible.

As illustrated in FIG. 35, the server 30E according to the embodiment is different from the server 30A according to the first embodiment in that the within-period reaction determination unit 13A is configured as a within-period reaction determination unit 13F performing a different process from the within-period reaction determination unit 13A. The server 30E according to the embodiment is different from the server 30A according to the first embodiment in that the reproduction control unit 14A is configured as a reproduction control unit 14F performing a different process form the reproduction control unit 14A.

The within-period reaction determination unit 13F of the server 30E corresponds to the within-period reaction determination unit 13 described above. The within-period reaction determination unit 13F determines whether there is the reaction within the period or there is no reaction within the period based on whether the reaction detection unit 12A detects the reaction at a predetermined period from a time point at which the voice section is detected by the sound acquisition unit 11A. In a case in which it is determined that there is the reaction within the period and subsequently the voice section included in the surrounding sound is not detected and the reaction is not detected, the within-period reaction determination unit 13F according to the embodiment determines that there is no reaction within the period.

The reproduction control unit 14F corresponds to the reproduction control unit 14 described above and performs control such that reproduction of content is restricted in a case in which the within-period reaction determination unit 13F determines that there is the reaction within the period. The reproduction control unit 14F according to the embodiment performs control such that the reproduction of the sound content is stopped in the case in which the within-period reaction determination unit 13F determines that there is the reaction within the period, and the reproduction of the sound content is continued in other cases.

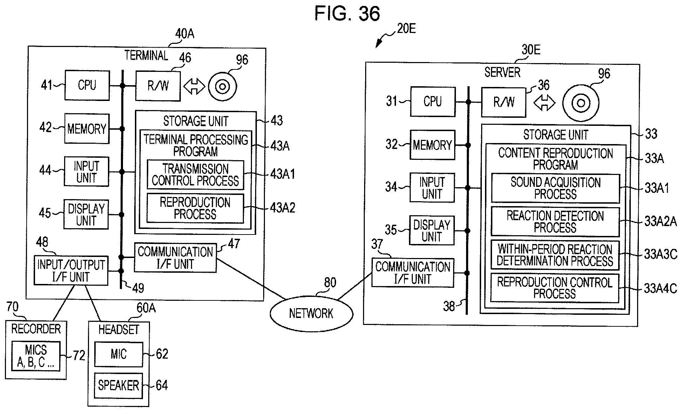

The server 30E and the terminal 40A described above can be respectively realized by a server 30E and a terminal 40A included in a computer system 20E illustrated in FIG. 36. The same reference numerals as those of FIG. 8 are given to the same constituent elements in FIG. 36 as those of FIG. 8, and the description thereof will be omitted as much as possible.

As illustrated in FIG. 36, the server 30E according to the embodiment is different from the server 30A according to the first embodiment in that the within-period reaction determination process 33A3A in the content reproduction program 33A is configured as a within-period reaction determination process 33A3C. The server 30E according to the embodiment is different from the server 30A according to the first embodiment in that the reproduction control process 33A4A in the content reproduction program 33A is configured as a reproduction control process 33A4C.

The CPU 31 operates the within-period reaction determination unit 13F illustrated in FIG. 35 by executing the within-period reaction determination process 33A3C and operates as the reproduction control unit 14F illustrated in FIG. 35 by executing the reproduction control process 33A4C. Accordingly, the server 30E executing the content reproduction program 33A functions as the server 30E illustrated in FIG. 35.

Next, operational effects of the embodiment will be described. The operational effects of the terminal 40A according to the embodiment are the same as those of the first embodiment, and thus the description thereof will be omitted here. Hereinafter, the operational effects of the server 30E will be described.

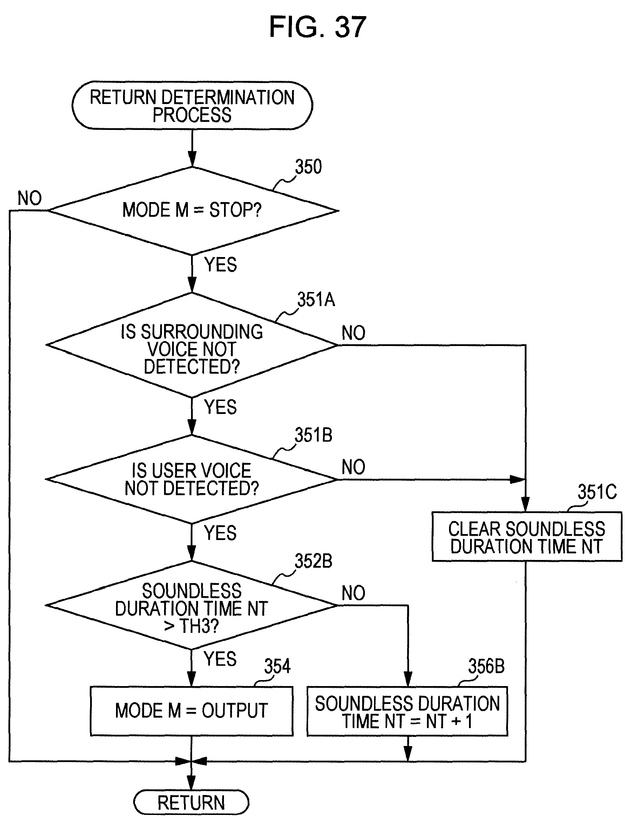

The server 30E performs the content reproduction process illustrated in FIG. 10 by executing the content reproduction program 33A when the access from the terminal 40A starts. However, the content reproduction process executed by the server 30E according to the embodiment is different from that of the first embodiment in that the return determination process executed in the output mode determination process is executed as a return determination process illustrated in FIG. 37.

Accordingly, only the return determination process will be described. The same reference numerals as those of FIG. 12 are given to the same steps of executing the same processes in FIG. 37 as those of FIG. 12, and the description thereof will be omitted as much as possible.

In step 350 of the return determination process, the reproduction control unit 14F determines whether the value indicating "stop" described above is set in the variable M. In a case in which the determination is positive, the process proceeds to step 351A.

In step 351A, the within-period reaction determination unit 13F determines whether the sound acquisition unit 11A does not detect the surrounding voice section. In a case in which the determination is negative, the process proceeds to step 351C to be described below. Conversely, in a case in which the determination is positive, the process proceeds to step 351B. In step 351B, the within-period reaction determination unit 13F determines whether the reaction detection unit 12A does not detect the user voice section. In a case in which the determination is negative, the process proceeds to step 351C.

In step 351C, the within-period reaction determination unit 13F clears a variable NT which is a variable indicating a time in which neither of the surrounding voice section nor the user voice section is present (hereinafter referred to as a "soundless duration time") (sets 0 (zero) in the embodiment). Thereafter, the return determination process ends.

Conversely, in a case in which the determination is positive in step 351B, the process proceeds to step 352B. Then, the within-period reaction determination unit 13F determines whether the soundless duration time indicated by the value of the variable NT exceeds a predetermined threshold value TH3. In a case in which the determination is the positive determination, the process proceeds to step 354. Conversely, in a case in which the determination is negative, the process proceeds to step 356B.

In step 356B, the within-period reaction determination unit 13F increases the value of the variable NT by a predetermined value ('1' in the embodiment) and subsequently the return determination process ends.

As described in detail above, in the embodiment, it is possible to obtain the same advantages as those of the first embodiment and to obtain the following advantage.

That is, in the embodiment after it is determined that there is the reaction within the period, that is, after the user can be estimated to be interested in the surrounding sound, the voice section included in the surrounding sound is not detected. In the case in which the reaction is not detected, it is determined that there is no reaction within the period and the user can be estimated not to be interested in the surrounding sound. Therefore, in the embodiment, the user can be estimated not to be interested in the surrounding sound with higher precision.

(Eighth Embodiment)

In an eighth embodiment, a case in which the content reproduction device 10 is applied to a system including a server, a terminal (desktop PC), a headset, and a recorder as in the first embodiment will be described.

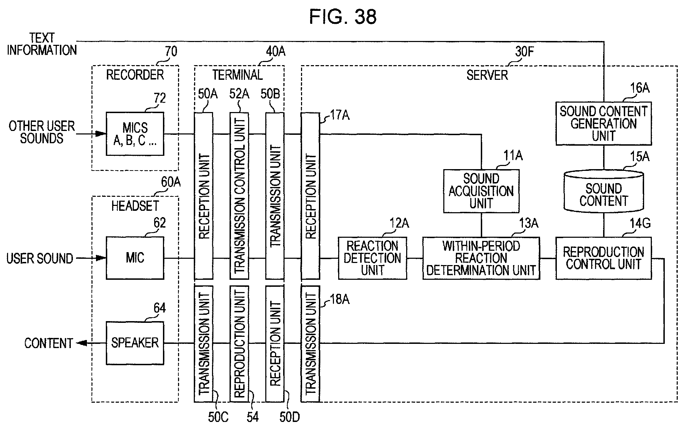

FIG. 38 illustrates a server 30F, a terminal 40A, a headset 60A, and a recorder 70 according to the embodiment. The same reference numerals as those of FIG. 6 are given to the same constituent elements in FIG. 38 as those of FIG. 6, and the description thereof will be omitted as much as possible.

As illustrated in FIG. 38, the server 30F according to the embodiment is different from the server 30A according to the first embodiment in that the reproduction control unit 14A is configured as a reproduction control unit 14G performing a different process form the reproduction control unit 14A.

The reproduction control unit 14G of the server 30F corresponds to the reproduction control unit 14 described above and performs control such that a part of content reproduced within the period in which the reaction within the predetermined period is continued is reproduced after the period in a case in which it is determined that there is the reaction within the period.

That is, the reproduction control unit 14G according to the embodiment does not perform control such that reproduction of the sound content is stopped even in a case in which it is determined that there is the reaction within the period and the user can be estimated to be interested in the surrounding sound. Here, the process of not stopping the reproduction of the sound content is a kind of technology of the present disclosure and the reproduction of the sound content may be stopped. In the case in which it is determined that there is no reaction within the period, the reproduction control unit 14G according to the embodiment again reproduces the part of the sound content reproduced within the period in which the detection of the reaction within the predetermined period is continued.

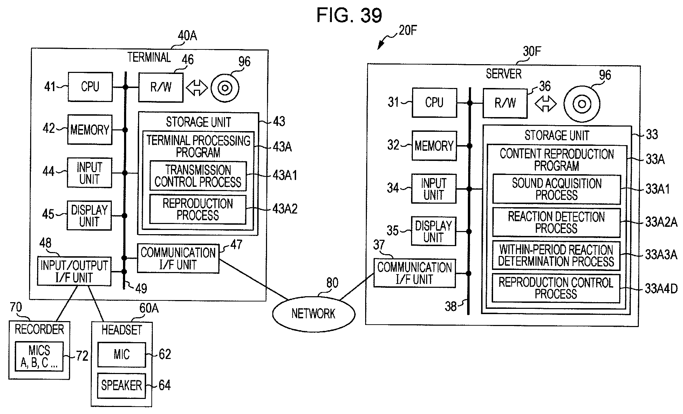

The server 30F and the terminal 40A described above can be respectively realized by a server 30F and a terminal 40A included in a computer system 20F illustrated in FIG. 39. The same reference numerals as those of FIG. 8 are given to the same constituent elements in FIG. 39 as those of FIG. 8, and the description thereof will be omitted as much as possible.

As illustrated in FIG. 39, the server 30F according to the embodiment is different from the server 30A according to the first embodiment in that the reproduction control process 33A4A in the content reproduction program 33A is configured as a reproduction control process 33A4D.

The CPU 31 operates as the reproduction control unit 14G illustrated in FIG. 38 by executing the reproduction control process 33A4D. Accordingly, the server 30F executing the content reproduction program 33A functions as the server 30F illustrated in FIG. 38.

Next, operational effects of the embodiment will be described. The operational effects of the terminal 40A according to the embodiment are the same as those of the first embodiment, and thus the description thereof will be omitted here. Hereinafter, the operational effects of the server 30F will be described.

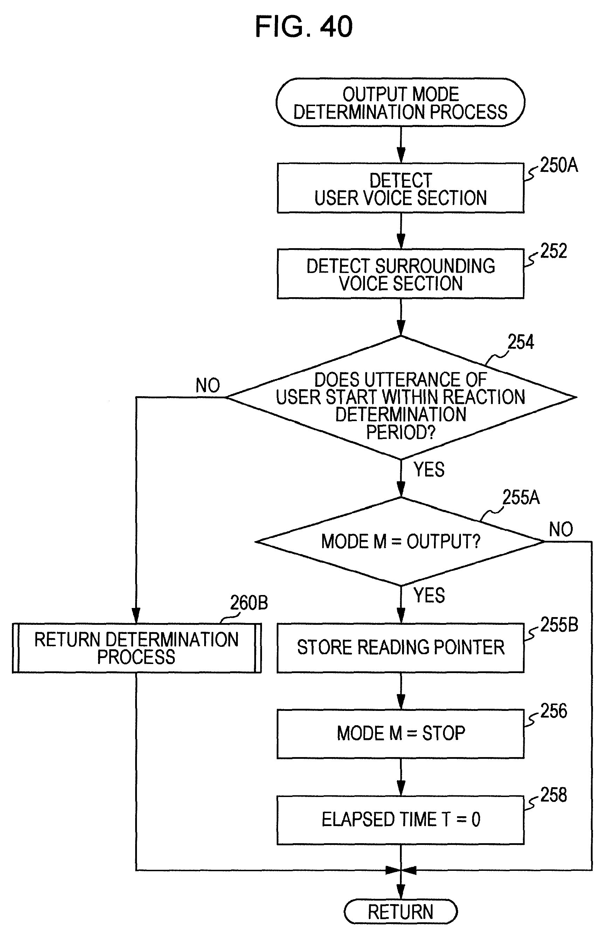

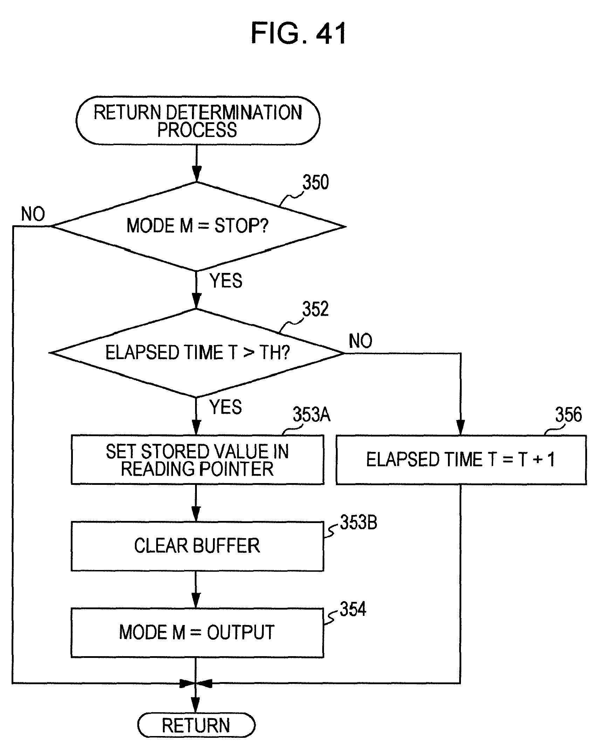

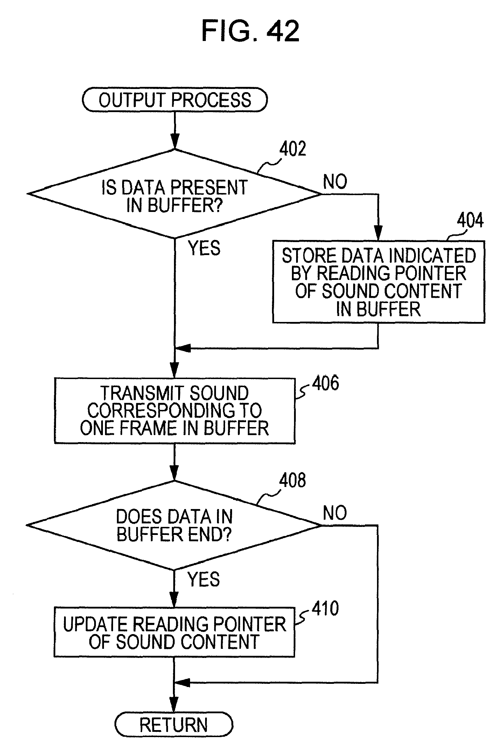

The server 30F performs the content reproduction process illustrated in FIG. 10 by executing the content reproduction program 33A when the access from the terminal 40A starts. However, the content reproduction process executed by the server 30F according to the embodiment is different from that of the first embodiment in that the output mode determination process executed in the content reproduction process is configured as an output mode determination process illustrated in FIG. 40. The output mode determination process executed by the server 30F according to the embodiment is different from that of the first embodiment in that the return determination process executed in the output mode determination process is configured as a return determination process illustrated in FIG. 41. The content reproduction process executed by the server 30F according to the embodiment is different from that of the first embodiment in that the output process executed in the content reproduction process is configured as an output process illustrated in FIG. 42.

Accordingly, only the output mode determination process, the return determination process, and the output process according to the embodiment will be described. The same reference numerals as those of FIG. 11 are given to the same steps of executing the same processes in FIG. 40 as those of FIG. 11, and the description thereof will be omitted as much as possible. The same reference numerals as those of FIG. 12 are given to the same steps of executing the same processes in FIG. 41 as those of FIG. 12, and the description thereof will be omitted as much as possible. The same reference numerals as those of FIG. 13 are given to the same steps of executing the same processes in FIG. 42 as those of FIG. 13, and the description thereof will be omitted as much as possible.

In a case in which the determination is positive in step 254 of the output mode determination process, the process proceeds to step 255A and the reproduction control unit 14G determines whether the value indicating "output" described above is set in the variable M. In a case in which the determination is positive, the process proceeds to step 255B. In step 255B, the reproduction control unit 14G stores the value of the first reading pointer in the memory 32 and subsequently the process proceeds to step 256. In a case in which the determination is negative in step 255A, the output mode determination process ends.

Conversely, in a case in which the determination is negative in step 254, the process proceeds to step 260B and the reproduction control unit 14G performs the return determination process illustrated in FIG. 41.

In a case in which the determination is positive in step 352 of the return determination process, the process proceeds to step 353A and the reproduction control unit 14G sets the value stored in the memory 32 in the first reading pointer through the process of step 255B. In subsequent step 353B, the reproduction control unit 14G clears the buffer memory 15A and subsequently the process proceeds to step 354.

On the other hand, in the output process according to the embodiment, steps 400, 412, and 414 in the output process according to the first embodiment illustrated in FIG. 13 are deleted. Accordingly, in the output process according to the embodiment, the content is normally reproduced irrespective of the reproduction mode. However, in a case in which the reproduction of the content is returned in the return determination process, the value of the first reading pointer at the time point at which the reproduction mode is set to "stop" is set in the first reading pointer and the content is reproduced. Therefore, the content reproduced at the time point at which the reproduction mode is set to "stop" is reproduced again.

As described in detailed above, in the embodiment, it is possible to obtain the same advantages as those of the first embodiment and obtain the following advantages.

In the embodiment, the reproduction control unit 14 performs the control such that the part of the content reproduced within the period in which the detection of the reaction within the predetermined period is continued is reduced again after the period in the case in which the within-period reaction determination unit 13 determines that there is the reaction within the period, that is, in the case in which the user can be estimated to be interested in the surrounding sound. Therefore, in the embodiment, the content can be reproduced even in the period in which the user can be estimated to be interested in the surrounding sound, and the same content can be reproduced after the period. Therefore, it is possible to further improve convenience for the user.

In the foregoing embodiments, the aspects have been described in which the content reproduction program, the terminal processing program, and the server processing program are read from the recording medium 96 to a storage unit of the corresponding device via medium reading and writing device, but the disclosure is not limited thereto. For example, the content reproduction program, the terminal processing program, and the server processing program may be stored (installed) in advance in the storage unit, or may be downloaded from an external device to the storage unit via the network 80.

All of the documents, the patent applications, and technical standards described in the present specification are incorporated by reference in the present specification just as the documents, the patent applications, and the technical standards are incorporated individually and specifically by reference.

**Claims**

1.  A content reproduction device comprising:

    a sound acquisition unit that acquires a first sound;
    an reaction detection unit that detects an reaction of a user;
    a within-period reaction determination unit that determines that there is an within-period reaction in a case in which the reaction is detected within a predetermined period from an acquisition time point of the first sound based on a temporal relation between the first sound acquired by the sound acquisition unit and the reaction detected by the reaction detection unit; and
    a reproduction control unit that performs control such that reproduction of content is restricted or performs control such that a part of the content reproduced within a period in which the detection of the reaction within the predetermined period continues is reproduced again after the period in the case in which the within-period reaction determination unit determines that there is the reaction within the period.

2.  The content reproduction device according to claim 1,
    wherein the sound acquisition unit detects a voice section included in the first sound.

3.  The content reproduction device according to claim 1,
    wherein the reaction detection unit acquires at least one of a position of a sensor, orientation of the sensor, a velocity of the sensor, acceleration of the sensor, a surrounding video, a second sound, and an input of a keyboard as an input signal and detects the reaction by detecting at least one of a look-back, a nod, a swing, an utterance, a body movement, delay of a keyboard input, and a movement of a visual line of the user from the input signal.

4.  The content reproduction device according to claim 3,
    wherein the reaction detection unit detects the reaction as the delay of the keyboard input in a case in which a frequency of the keyboard input is decreased by a predetermined value or more.

5.  The content reproduction device according to claim 2,
    wherein a starting point of the predetermined period is a time point at which the voice section of the first sound acquired by the sound acquisition unit starts, and an ending point of the predetermined period is a time point at which a predetermined time has passed from the end of the voice section.

6.  The content reproduction device according to claim 2,
    wherein the within-period reaction determination unit determines that there is the within-period reaction and subsequently determines that there is no within-period reaction in a case in which the reaction detection unit does not detect the reaction within a predetermined elapsed time from a time point at which the sound acquisition unit detects the voice section, and

wherein the reproduction control unit cancels the control performed such that it is determined that there is the within-period reaction in the case in which the within-period reaction determination unit determines that there is no within-period reaction.

**7.** The content reproduction device according to claim 2,
wherein the within-period reaction determination unit determines that there is the within-period reaction and subsequently determines that there is no within-period reaction in a case in which the sound acquisition unit does not detect the voice section and the reaction detection unit does not detect the reaction, and
wherein the reproduction control unit cancels the control performed such that it is determined that there is the within-period reaction in the case in which the within-period reaction determination unit determines that there is no within-period reaction.

**8.** The content reproduction device according to claim 6,
wherein the reproduction control unit performs control such that reproduction of the content stops in the case in which the within-period reaction determination unit determines that there is the within-period reaction, and the reproduction control unit performs control such that the reproduction of the content resumes in the case in which the within-period reaction determination unit determines that there is no within-period reaction during when the reproduction control unit performs the control such that the reproduction of the content stops.

**9.** The content reproduction device according to claim 6,
wherein the reproduction control unit performs control such that a reproduction speed of the content is reduced in the case in which the within-period reaction determination unit determines that there is the within-period reaction, and the reproduction control unit performs control such that the reproduction speed of the content returns to an original speed in a case in which the within-period reaction determination unit determines that there is no reaction during when the reproduction control unit performs the control such that the reproduction speed of the content is reduced.

**10.** The content reproduction device according to claim 6,
wherein the content is content of which a sound is reproduced, and
wherein the reproduction control unit performs control such that a reproduction volume of the content is reduced in the case in which the within-period reaction determination unit determines that there is the within-period reaction, and the reproduction control unit performs control such that the reproduction volume of the content returns to an original volume in a case in which the within-period reaction determination unit determines that there is no within-period reaction during when the reproduction control unit performs the control such that the reproduction volume of the content is reduced.

**11.** A non-transitory computer-readable storage medium recording a content reproduction program which causes a computer to execute a process comprising:

acquiring a first sound;
detecting an reaction of a user;
determining that there is an within-period reaction in a case in which the reaction is detected within a predetermined period from an acquisition time point of the first sound based on a temporal relation between the acquired first sound and the detected reaction; and
performing control such that reproduction of content is restricted or performing control such that a part of the content reproduced within a period in which the detection of the reaction within the predetermined period continues is reproduced again after the period in the case in which it is determined that there is the within-period reaction.

**12.** A content reproduction method for a content reproduction device which comprises a computer, **characterized in that** the content reproduction method comprising:

acquiring a first sound;
detecting an reaction of a user;
determining that there is an within-period reaction in a case in which the reaction is detected within a predetermined period from an acquisition time point of the first sound based on a temporal relation between the acquired first sound and the detected reaction; and

performing control such that reproduction of content is restricted or performing control such that a part of the content reproduced within a period in which the detection of the reaction within the predetermined period continues is reproduced again after the period in the case in which it is determined that there is the within-period reaction.

FIG. 1

# FIG. 2

★ IN CASE OF CONVERSATION

SURROUNDING SOUND —————— THOUGH THIS CASE,

DT

REACTION
(UTTERANCE) ————————— YES

OVER TIME

OVER TIME

tus
toe

★ IN CASE OF NO CONVERSATION (DURING CONVERSATION OF PEOPLE AROUND)

SURROUNDING SOUND ——— THOUGH THIS CASE, | YES

OVER TIME

REACTION
(UTTERANCE) —————————

OVER TIME

NO REACTION (UTTERANCE) OF USER AFTER SURROUNDING SOUND

# FIG. 3

```
   ┌──────────────────────────┐
   │  CONTENT REPRODUCTION    │
   │         PROCESS          │
   └──────────────────────────┘
                │
                ▼
   ┌──────────────────────────┐  ⌇100
   │     MODE M = OUTPUT      │
   └──────────────────────────┘
                │
                ▼
   ┌──────────────────────────┐  ⌇102
   │      OUTPUT MODE         │
   │  DETERMINATION PROCESS   │
   └──────────────────────────┘
                │
                ▼                    106
         ◇──────────────◇
   NO    │ MODE M = OUTPUT? │
   ◄─────│                  │
         ◇──────────────◇
                │ YES
                ▼
   ┌──────────────────────────┐  ⌇108
   │     REPRODUCE CONTENT    │
   └──────────────────────────┘
                │
                ▼                    110
         ◇──────────────◇
   NO    │ DOES REPRODUCTION │
   ◄─────│       END?        │
         ◇──────────────◇
                │ YES
                ▼
          ┌──────────┐
          │   END    │
          └──────────┘
```

# FIG. 4

```
         ┌──────────────────────────┐
         │     OUTPUT MODE          │
         │ DETERMINATION PROCESS    │
         └──────────────────────────┘
                     │
                     ▼
                    ╱╲           200
         NO       ╱    ╲
    ◄──────────  ╱ IS VOICE ╲
               ╱  SECTION     ╲
               ╲  DETECTED?   ╱
                ╲            ╱
                  ╲  ╱  YES
                    │
                    ▼
                   ╱╲            202
                 ╱    ╲
               ╱ IS REACTION ╲      NO
              ╱ PERFORMED WITHIN ╲ ────►
              ╲ REACTION DETERMINATION ╱
               ╲    PERIOD?   ╱
                 ╲          ╱
                   ╲  YES  ╱
                    │
```

```
┌─────────────────────┐   ┌──────────────────┐   ┌──────────────────┐
│ RETURN DETERMINATION│   │ MODE M = STOP    │   │ MODE M = OUTPUT  │
│      PROCESS    210 │   │            204   │   │            208   │
└─────────────────────┘   └──────────────────┘   └──────────────────┘
                                   │
                                   ▼
                          ┌──────────────────┐
                          │ ELAPSED TIME T = 0│  206
                          └──────────────────┘
                                   │
                                   ▼
                          ┌──────────────┐
                          │   RETURN     │
                          └──────────────┘
```

35

# FIG. 5

RETURN DETERMINATION
PROCESS

300

NO ← MODE M = STOP?

YES

302

ELAPSED TIME T > TH? → NO

YES

304

MODE M = OUTPUT

306

ELAPSED TIME T = T + 1

RETURN

# FIG. 6

TEXT INFORMATION

| | 70 | | 40A | | | 30A | | |
|---|---|---|---|---|---|---|---|---|

RECORDER

TERMINAL

SERVER

OTHER USER SOUNDS → MICS A, B, C ... (72)

SOUND CONTENT GENERATION UNIT (16A)

HEADSET (60A)

RECEPTION UNIT (50A)

TRANSMISSION CONTROL UNIT (52A)

TRANSMISSION UNIT (50B)

RECEPTION UNIT (17A)

SOUND ACQUISITION UNIT (11A)

SOUND CONTENT (15A)

USER SOUND → MIC (62)

REACTION DETECTION UNIT (12A)

WITHIN-PERIOD REACTION DETERMINATION UNIT (13A)

REPRODUCTION CONTROL UNIT (14A)

CONTENT ← SPEAKER (64)

TRANSMISSION UNIT (50C)

REPRODUCTION UNIT (54)

RECEPTION UNIT (50D)

TRANSMISSION UNIT (18A)

# FIG. 7

SOUND CONTENT

15A

| ADDRESS | SOUND DATA |
|---------|------------|
| 1 | (DEAR SIRS) |
| 2 | (TODAY,) |
| ⋮ | ⋮ |
| N−1 | (PLEASE) |
| N | (REGARDS) |

## FIG. 8

# FIG. 9

```
        ( TERMINAL PROCESSING )
                    │
                    ▼
        ┌───────────────────────┐      500
        │   TRANSMIT USER SOUND  │────╮
        │ AND SURROUNDING SOUND  │
        └───────────────────────┘
                    │
                    ▼
                   ╱ ╲              502
         NO      ╱     ╲ ────╮
       ◄───────◄  IS SOUND  ►
                ╲ RECEIVED? ╱
                  ╲       ╱
                    ╲   ╱
                     YES
                    │
                    ▼
        ┌───────────────────────┐      504
        │    REPRODUCE SOUND     │────╮
        └───────────────────────┘
                    │
                    ▼
                   ╱ ╲              506
         NO      ╱     ╲ ────╮
       ◄───────◄ DOES USE END? ►
                ╲         ╱
                  ╲     ╱
                    ╲ ╱
                    YES
                    │
                    ▼
                ( END )
```

# FIG. 10

```
        ┌─────────────────────────┐
        │  CONTENT REPRODUCTION   │
        │        PROCESS          │
        └─────────────────────────┘
                    │
                    ▼
        ┌─────────────────────────┐ ⌐150
        │     MODE M = OUTPUT     │
        └─────────────────────────┘
                    │
                    ▼
        ┌─────────────────────────┐ ⌐152
        │    INPUT INFORMATION    │
        └─────────────────────────┘
                    │
                    ▼
              ╱──────────╲  ⌐154
             ╱  IS INPUT  ╲      NO
            ╱  PERFORMED?  ╲──────────┐
             ╲            ╱           │
              ╲──────────╱            │
                  │ YES               │
                  ▼                   │
        ┌─────────────────────────┐ ⌐156 │
        │   GENERATE AND STORE    │    │
        │        CONTENT          │    │
        └─────────────────────────┘    │
                    │                  │
                    ▼◄─────────────────┘
              ╱──────────╲  ⌐158
       NO    ╱ IS SOUND DATA╲
      ┌──────╲   RECEIVED?  ╱
      │        ╲          ╱
      │         ╲────────╱
      │             │ YES
      │             ▼
      │   ┌─────────────────────────┐ ⌐160
      │   │      OUTPUT MODE         │
      │   │ DETERMINATION PROCESS    │
      │   └─────────────────────────┘
      │             │
      │             ▼
      │   ┌─────────────────────────┐ ⌐162
      │   │     OUTPUT PROCESS       │
      │   └─────────────────────────┘
      │             │
      │             ▼
      │       ╱──────────╲  ⌐164
      │  NO  ╱ DOES CONNECTION╲
      └──────╲     END?      ╱
              ╲            ╱
               ╲──────────╱
                   │ YES
                   ▼
              ┌─────────┐
              │   END   │
              └─────────┘
```

# FIG. 11

```
        ┌─────────────────────────────┐
        │      OUTPUT MODE            │
        │  DETERMINATION PROCESS     │
        └─────────────────────────────┘
                      │
                      ▼
        ┌─────────────────────────────┐
        │        DETECT               │  ⌒250A
        │   USER VOICE SECTION        │
        └─────────────────────────────┘
                      │
                      ▼
        ┌─────────────────────────────┐
        │   DETECT SURROUNDING        │  ⌒252
        │      VOICE SECTION          │
        └─────────────────────────────┘
                      │
                      ▼
                                          254
                  ◇─────────────────────◇
        NO        │  DOES UTTERANCE OF   │
   ◄──────────────│  USER START WITHIN   │
                  │  REACTION            │
                  │  DETERMINATION       │
                  │     PERIOD?          │
                  ◇─────────────────────◇
                            │ YES
                            ▼
 ┌──────────────────┐   ┌─────────────────────┐
 │RETURN DETERMINATION│  │   MODE M = STOP     │  ⌒256
 │     PROCESS      │   └─────────────────────┘
 └──────────────────┘            │
      260                         ▼
        │            ┌─────────────────────┐
        │            │  ELAPSED TIME T = 0 │  ⌒258
        │            └─────────────────────┘
        │                         │
        └─────────────────►       ▼
                         ┌──────────────┐
                         │    RETURN    │
                         └──────────────┘
```

# FIG. 12

```
        ┌──────────────────────────┐
        │  RETURN DETERMINATION    │
        │        PROCESS           │
        └──────────────────────────┘
                    │
                    ▼                  350
NO      ◇ MODE M = STOP? ◇
◄───────
                    │ YES
                    ▼                  352
        ◇ ELAPSED TIME T > TH? ◇          NO
                    │                  ───────►
                    │ YES    354                          356
        ┌────────────────────┐    ┌──────────────────────┐
        │  MODE M = OUTPUT   │    │  ELAPSED TIME T = T + 1 │
        └────────────────────┘    └──────────────────────┘
                    │
                    ▼
            ┌──────────┐
            │  RETURN  │
            └──────────┘
```

# FIG. 13

```
                    ( OUTPUT PROCESS )
                            │
                            ▼
                                        400
      NO         < MODE M = OUTPUT? >
  ┌──────────────                              
  │                         │ YES
  │                         ▼
  │                                        402
  │                  < IS DATA PRESENT >      NO
  │                  <   IN BUFFER?    >──────────┐
  │              412        │                     │      404
  ▼                         │ YES                 ▼
┌──────────────┐            │         ┌─────────────────────────┐
│ CLEAR BUFFER │            │         │  STORE DATA INDICATED   │
└──────────────┘            │         │  BY READING POINTER     │
  │                         │         │  OF SOUND CONTENT       │
  │             414         │         │     IN BUFFER           │
  ▼                         │         └─────────────────────────┘
┌──────────────────┐        │                     │
│ TRANSMIT EMPTY   │        │                     │
│ DATA CORRESPONDING│       │◄────────────────────┘
│ TO ONE FRAME     │        │
└──────────────────┘        ▼
  │                      406
  │         ┌─────────────────────────┐
  │         │   TRANSMIT SOUND        │
  │         │   CORRESPONDING TO      │
  │         │ ONE FRAME IN BUFFER     │
  │         └─────────────────────────┘
  │                     │
  │                     ▼              408
  │            < DOES DATA IN >    NO
  │            <  BUFFER END?  >─────────┐
  │                     │ YES           │
  │                     ▼           410 │
  │         ┌─────────────────────────┐ │
  │         │ UPDATE READING POINTER  │ │
  │         │   OF SOUND CONTENT      │ │
  │         └─────────────────────────┘ │
  │                     │               │
  └─────────────────────┼───────────────┘
                        ▼
                  ( RETURN )
```

FIG. 14

# FIG. 15

SOUND CONTENT ⌐15A

| ADDRESS | SOUND DATA |
|---------|-----------------------|
| 1 | (TOMORROW) |
| 2 | (WEATHER) |
| ⋮ | ⋮ |
| N−1 | (FROM AFTERNOON) |
| N | (IT IS LIKELY TO RAIN) |

FIG. 16

**TERMINAL** 40B

41 — CPU

46 R/W ⇔ ◎ 96

42 — MEMORY

44 — INPUT UNIT

45 — DISPLAY UNIT

56A — MIC

48 INPUT/OUTPUT I/F UNIT

49

**STORAGE UNIT** — 43
CONTENT REPRODUCTION PROGRAM — 43B
SOUND ACQUISITION PROCESS — 43B1
REACTION DETECTION PROCESS — 43B2
WITHIN-PERIOD REACTION DETERMINATION PROCESS — 43B3
FIRST REPRODUCTION CONTROL PROCESS — 43B4
REPRODUCTION PROCESS — 43B5
TRANSMISSION CONTROL PROCESS — 43B6

COMMUNICATION I/F UNIT — 47

HEADSET — 60A
MIC — 62
SPEAKER — 64

20B

NETWORK — 80

**SERVER** 30B

31 — CPU

36 R/W ⇔ ◎ 96

32 — MEMORY

34 — INPUT UNIT

35 — DISPLAY UNIT

37 COMMUNICATION I/F UNIT

38

**STORAGE UNIT** 33
SERVER PROCESSING PROGRAM — 33C
SECOND REPRODUCTION CONTROL PROCESS
33C1

# FIG. 17

CONTENT REPRODUCTION
PROCESS

TRANSMIT INPUT INFORMATION ⟍600

DETECT USER SOUND SECTION ⟍602

DETECT SURROUNDING
VOICE SECTION ⟍604

DOES UTTERANCE OF
USER START WITHIN REACTION
DETERMINATION
PERIOD? ⟍606

NO

YES

RETURN DETERMINATION
PROCESS ⟍612

MODE M = STOP ⟍608

ELAPSED TIME T = 0 ⟍610

TRANSMIT REPRODUCTION
MODE ⟍614

IS SOUND RECEIVED? ⟍616

NO

YES

REPRODUCE SOUND ⟍618

DOES USE END? ⟍620

NO

YES

END

# FIG. 18

RETURN DETERMINATION PROCESS

MODE M = STOP? `700`

NO

YES

ELAPSED TIME T > TH? `702`

NO

YES

MODE M = OUTPUT `704`

ELAPSED TIME T = T + 1 `706`

RETURN

# FIG. 19

```
                    SERVER PROCESSING

                            │
                            ▼
            ┌──────────────────────────────┐  ⌇170
            │      MODE M = OUTPUT          │
            └──────────────────────────────┘
                            │
        ┌──────────────────►│
        │                   ▼
        │   ┌──────────────────────────────┐  ⌇172
        │   │        RECEIVE INPUT          │
        │   └──────────────────────────────┘
        │                   │
        │                   ▼               174
        │              ◇─────────◇           NO
        │         ╱  IS INPUT PERFORMED?  ╲──────┐
        │              ◇─────────◇                │
        │                   │ YES                 │
        │                   ▼                     │
        │   ┌──────────────────────────────┐ ⌇176│
        │   │    GENERATE AND STORE         │     │
        │   │         CONTENT               │     │
        │   └──────────────────────────────┘     │
        │                   │◄────────────────────┘
        │                   ▼           178
        │  NO          ◇─────────◇
        │◄────────╱  IS REPRODUCTION  ╲
        │            ╲ MODE RECEIVED? ╱
        │              ◇─────────◇
        │                   │ YES
        │                   ▼
        │   ┌──────────────────────────────┐  ⌇180
        │   │       OUTPUT PROCESS          │
        │   └──────────────────────────────┘
        │                   │
        │                   ▼           182
        │  NO          ◇─────────◇
        └────────╱  DOES CONNECTION  ╲
                    ╲     END?       ╱
                      ◇─────────◇
                            │ YES
                            ▼
                         ( END )
```

## FIG. 20

# FIG. 21

40C

TERMINAL

| 41 | CPU |
|---|---|

46 R/W ⇔ 96 (◎)

STORAGE UNIT — 43

CONTENT REPRODUCTION PROGRAM — 43C

| 42 | MEMORY |
|---|---|

SOUND ACQUISITION PROCESS — 43C1

| 44 | INPUT UNIT |
|---|---|

REACTION DETECTION PROCESS — 43C2

WITHIN-PERIOD REACTION DETERMINATION PROCESS — 43C3

| 45 | DISPLAY UNIT |
|---|---|

REPRODUCTION CONTROL PROCESS — 43C4

REPRODUCTION PROCESS — 43C5

| 56B | MIC ARRAY |
|---|---|

COMMUNICATION I/F UNIT — 47

| 58 | CAMERA |
|---|---|

| 59 | KEYBOARD |
|---|---|

48

| INPUT/OUTPUT I/F UNIT |
|---|

49

| HEADSET | 60A |
|---|---|
| MIC | 62 |
| SPEAKER | 64 |

## FIG. 22

```
┌─────────────────────────────┐
│   CONTENT REPRODUCTION       │
│        PROCESS               │
└─────────────────────────────┘
              │
              ▼
┌─────────────────────────────┐ ⌐650
│      MODE M = OUTPUT         │
└─────────────────────────────┘
              │
              ▼◄───────────────────────────────────┐
┌─────────────────────────────┐ ⌐652              │
│   DETECT USER VOICE SECTION  │                   │
└─────────────────────────────┘                   │
              │                                     │
              ▼                                     │
┌─────────────────────────────┐ ⌐654              │
│ DETECT SURROUNDING VOICE SECTION │               │
└─────────────────────────────┘                   │
              │                                     │
              ▼                                     │
┌─────────────────────────────┐ ⌐656              │
│   DETECT MOVEMENT REACTION   │                   │
└─────────────────────────────┘                   │
              │                                     │
              ▼                                     │
┌─────────────────────────────┐ ⌐658              │
│     DETECT HEAD REACTION     │                   │
└─────────────────────────────┘                   │
              │                                     │
              ▼                                     │
┌─────────────────────────────┐ ⌐660              │
│  DETECT VISUAL LINE REACTION │                   │
└─────────────────────────────┘                   │
              │                                     │
              ▼                                     │
┌─────────────────────────────┐ ⌐662              │
│   DETECT KEYBOARD REACTION   │                   │
└─────────────────────────────┘                   │
              │                                     │
              ▼           664                       │
          ◇ IS USER ◇                              │
  NO   ◇ REACTION PERFORMED ◇                      │
◄──────◇ WITHIN REACTION ◇                         │
       ◇ DETERMINATION ◇                            │
           ◇ PERIOD? ◇                             │
              │ YES                                 │
              ▼          666                        │
          ◇ DURATION TIME ◇   NO                   │
   674    ◇ KT ≥ THRESHOLD ◇──────┐               │
          ◇   VALUE?   ◇          │               │
              │ YES               ▼               │
              ▼      668    ┌──────────────┐       │
        ┌──────────┐        │DURATION TIME KT│ ⌐670 │
DURATION TIME      │MODE M = CONTROL│ │= DURATION TIME KT│
│ KT = 0 │         └──────────┘  │+ ELAPSED TIME T│
└──────────┘            │        └──────────────┘
    │   676             ▼              │
    ▼          ┌──────────────┐ ⌐672  │
┌──────────┐   │ ELAPSED TIME T = 0 │◄─┘
│  RETURN  │   └──────────────┘
│DETERMINATION│        │
│ PROCESS  │          │
└──────────┘          │
    │                 │
    └────────►────────┤
                      ▼
            ┌──────────────┐ ⌐678
            │ OUTPUT PROCESS │
            └──────────────┘
                      │
                      ▼      680
                  ◇ DOES USE END? ◇  NO
                  ◇              ◇───────►
                      │ YES
                      ▼
                 ┌──────────┐
                 │   END    │
                 └──────────┘
```

# FIG. 23

```
        ( OUTPUT PROCESS )
                │
                ▼
   ┌────────────────────────────┐  ⟋450
   │      ACQUIRE DATA S(t)      │
   │      CORRESPONDING TO       │
   │  ONE FRAME FROM CONTENT     │
   └────────────────────────────┘
                │
                ▼
           ╱╲          452
         ╱     ╲      ⟋
       ╱         ╲         NO
      ╱ MODE M =   ╲──────────────┐
      ╲  OUTPUT?   ╱              │
       ╲         ╱                ▼
         ╲     ╱           ┌──────────────────┐ ⟋454
           ╲╱  YES         │  S(t) = S(t) × G │
            │              └──────────────────┘
            │                      │
            ◄──────────────────────┘
            │
            ▼
   ┌────────────────────────────┐ ⟋456
   │        REPRODUCE S(t)       │
   └────────────────────────────┘
            │
            ▼
       ( RETURN )
```

# FIG. 24

# FIG. 25

40D

TERMINAL

41 — CPU

46 — R/W ⟺ ◎ 96

42 — MEMORY

44 — INPUT UNIT

STORAGE UNIT — 43

CONTENT REPRODUCTION PROGRAM — 43D

SOUND ACQUISITION PROCESS — 43D1

REACTION DETECTION PROCESS — 43D2

WITHIN-PERIOD REACTION DETERMINATION PROCESS — 43D3

REPRODUCTION CONTROL PROCESS — 43D4

REPRODUCTION PROCESS — 43D5

51

MOTION DETECTION SENSOR

SPEAKER — 55

53 — MIC

DISPLAY — 57

56B — MIC ARRAY

49

FIG. 26

```
        ┌─────────────────────────┐
        │  CONTENT REPRODUCTION   │
        │        PROCESS          │
        └─────────────────────────┘
                    │
        ┌─────────────────────────┐ ⟍650
        │    MODE M = OUTPUT      │
        └─────────────────────────┘
                    │
        ┌─────────────────────────┐ ⟍652
        │ DETECT USER VOICE SECTION│
        └─────────────────────────┘
                    │
        ┌─────────────────────────┐ ⟍654
        │   DETECT SURROUNDING    │
        │     VOICE SECTION       │
        └─────────────────────────┘
                    │
        ┌─────────────────────────┐ ⟍656B
        │ DETECT MOVEMENT REACTION │
        └─────────────────────────┘
                    │
        ┌─────────────────────────┐ ⟍658B
        │   DETECT HEAD REACTION   │
        └─────────────────────────┘
```

664B IS USER REACTION PERFORMED WITHIN REACTION DETERMINATION PERIOD?

NO     YES

666B NUMBER OF DURATIONS KN ≥ THRESHOLD VALUE?

NO     YES

674B NUMBER OF DURATIONS KN = 0

670B NUMBER OF DURATIONS KN = NUMBER OF DURATIONS KN + 1

668 MODE M = CONTROL

676 RETURN DETERMINATION PROCESS

672 ELAPSED TIME T = 0

678B OUTPUT PROCESS

680 DOES USE END?

NO

YES

END

# FIG. 27

```
        ( OUTPUT PROCESS )
                 │
                 ▼
            ╱─────────╲  470              NO
          ╱             ╲
         ⟨ MODE M = OUTPUT? ⟩──────────────────┐
          ╲             ╱                       │
            ╲─────────╱                         │
                 │ YES                          │
                 │     472                      │
                 ▼                              ▼
      ┌────────────────────┐          ┌──────────────────────────┐
      │   ACQUIRE DATA     │ 472      │      ACQUIRE DATA        │ 474
      │  CORRESPONDING TO  │          │   CORRESPONDING TO       │
      │ONE FRAME FROM CONTENT│        │ONE FRAME × N FROM CONTENT│
      └────────────────────┘          └──────────────────────────┘
                 │                              │
                 │                              ▼
                 │                   ┌──────────────────────┐
                 │                   │  CORRECT SPEED OF    │ 476
                 │                   │   VIDEO AND SOUND    │
                 │                   └──────────────────────┘
                 │◄─────────────────────────────┘
                 ▼
      ┌────────────────────┐ 478
      │   REPRODUCE DATA   │
      └────────────────────┘
                 │
                 ▼
           ( RETURN )
```

## FIG. 28

TEXT INFORMATION

RECORDER 70

MICS A, B, C ... 72

OTHER USER SOUNDS

TERMINAL 40A

RECEPTION UNIT 50A

TRANSMISSION CONTROL UNIT 52A

TRANSMISSION UNIT 50B

SERVER 30C

RECEPTION UNIT 17A

SOUND ACQUISITION UNIT 11A

REACTION DETECTION UNIT 12E

WITHIN-PERIOD REACTION DETERMINATION UNIT 13A

SOUND CONTENT GENERATION UNIT 16A

SOUND CONTENT 15A

REPRODUCTION CONTROL UNIT 14A

HEADSET 60B

SPEAKER 64

CONTENT

TRANSMISSION UNIT 50C

REPRODUCTION UNIT 54

RECEPTION UNIT 50D

TRANSMISSION UNIT 18A

## FIG. 29

# FIG. 30

```
        OUTPUT MODE
   DETERMINATION PROCESS
             │
             ▼
         DETECT                    ⌇250B
    USER VOICE SECTION
             │
             ▼
     DETECT SURROUNDING           ⌇252
       VOICE SECTION
             │
             ▼
                                254
        DOES UTTERANCE OF
   NO   USER START WITHIN REACTION
◄────    DETERMINATION
          PERIOD?
                      │
                     YES
                      │
    260               ▼
RETURN DETERMINATION      MODE M = STOP        ⌇256
     PROCESS
                          │
                          ▼
                     ELAPSED TIME T = 0        ⌇258
      │                   │
      └──────────►────────┤
                          ▼
                       RETURN
```

## FIG. 31

FIG. 32

# FIG. 33

```
         ┌─────────────────────────┐
         │     OUTPUT MODE         │
         │ DETERMINATION PROCESS   │
         └─────────────────────────┘
                     │
                     ▼
         ┌─────────────────────────┐  ⌇250A
         │        DETECT           │
         │  USER VOICE SECTION     │
         └─────────────────────────┘
                     │
                     ▼
         ┌─────────────────────────┐  ⌇252
         │  DETECT SURROUNDING     │
         │     VOICE SECTION       │
         └─────────────────────────┘
                     │
                     ▼          253A
              ◇─────────────────◇         NO
              │     WITHIN       │──────────────┐
              │ REACTION DETERMINATION │        │
              │     PERIOD?      │              │
              ◇─────────────────◇              │
                     │ YES                      │
                     ▼                          │
         ┌─────────────────────────┐  ⌇253B    │
         │      CALCULATE          │           │
         │  REACTION FREQUENCY     │           │
         └─────────────────────────┘           │
                     │                          │
                     ▼          253C            │
              ◇─────────────────◇              │
        NO    │ REACTION FREQUENCY │           │
    ┌─────────│      > TH2?      │             │
    │         ◇─────────────────◇              │
    │                │ YES                      │
    ▼ 260C           ▼              256         │
┌──────────────┐  ┌──────────────┐             │
│ RETURN DETERMINATION │  MODE M = STOP │       │
│   PROCESS    │  │              │             │
└──────────────┘  └──────────────┘             │
    │                │                          │
    └────────────────┼──────────────────────────┘
                     ▼
              ┌──────────┐
              │  RETURN  │
              └──────────┘
```

# FIG. 34

```
┌─────────────────────────┐
│  RETURN DETERMINATION   │
│        PROCESS          │
└─────────────────────────┘
            │
            ▼
         ╱──────────╲              350
   NO  ╱   MODE M =   ╲
◄─────╱     STOP?      ╲
      ╲                ╱
       ╲──────────────╱
            │
           YES
            │
            ▼
┌─────────────────────────┐      354
│     MODE M = OUTPUT     │
└─────────────────────────┘
            │
            ▼
      ┌──────────┐
      │  RETURN  │
      └──────────┘
```

FIG. 35

FIG. 36

# FIG. 37

```
        ┌─────────────────────────┐
        │  RETURN DETERMINATION   │
        │        PROCESS          │
        └─────────────────────────┘
                     │
                     ▼                    350
NO    ◇─────────────────────────────◇
◄─────│      MODE M = STOP?          │
      ◇─────────────────────────────◇
                     │ YES
                     ▼                    351A
      ◇─────────────────────────────◇   NO
      │      IS SURROUNDING          │──────────┐
      │      VOICE NOT               │          │
      │      DETECTED?               │          │
      ◇─────────────────────────────◇          │
                     │ YES                      │
                     ▼                351B       │
      ◇─────────────────────────────◇   NO      │
      │      IS USER VOICE           │──────────┤
      │      NOT DETECTED?           │          │
      ◇─────────────────────────────◇          │
                     │ YES                      ▼        351C
                     │                ┌──────────────────────┐
                     ▼      352B      │  CLEAR SOUNDLESS      │
      ◇─────────────────────────────◇│  DURATION TIME NT     │
      │      SOUNDLESS               │ └──────────────────────┘
      │      DURATION TIME NT        │   NO
      │      > TH3?                  │──────────┐
      ◇─────────────────────────────◇          │
                     │ YES    354               │    356B
                     ▼                          ▼
      ┌─────────────────────┐      ┌──────────────────────┐
      │   MODE M = OUTPUT   │      │  SOUNDLESS DURATION   │
      └─────────────────────┘      │  TIME NT = NT + 1     │
                     │             └──────────────────────┘
                     ▼                          │
              ┌─────────────┐                   │
              │   RETURN    │◄──────────────────┘
              └─────────────┘
```

68

## FIG. 38

FIG. 39

# FIG. 40

```
        ┌──────────────────────────┐
        │    OUTPUT MODE           │
        │ DETERMINATION PROCESS    │
        └────────────┬─────────────┘
                     │
                     ▼
        ┌──────────────────────────┐  250A
        │        DETECT            │
        │  USER VOICE SECTION      │
        └────────────┬─────────────┘
                     │
                     ▼
        ┌──────────────────────────┐  252
        │  DETECT SURROUNDING      │
        │    VOICE SECTION         │
        └────────────┬─────────────┘
                     │
                     ▼
                                    254
              ╱────────────────────╲
        NO   ╱   DOES UTTERANCE OF   ╲
   ◄────────  USER START WITHIN REACTION
             ╲   DETERMINATION       ╱
              ╲     PERIOD?         ╱
               ╲──────────┬────────╱
                          │ YES
                          ▼
                                    255A
              ╱────────────────────╲    NO
             ╱   MODE M = OUTPUT?    ╲──────►
              ╲────────────┬────────╱
                           │ YES
```

ELAPSED TIME T = 0

RETURN DETERMINATION PROCESS   260B

STORE READING POINTER   255B

MODE M = STOP   256

ELAPSED TIME T = 0   258

RETURN

# FIG. 41

RETURN DETERMINATION
PROCESS

350
MODE M = STOP?

NO

YES

352
ELAPSED TIME T > TH?

NO

YES

353A
SET STORED VALUE IN
READING POINTER

356
ELAPSED TIME T = T + 1

353B
CLEAR BUFFER

354
MODE M = OUTPUT

RETURN

# FIG. 42

( OUTPUT PROCESS )

402

IS DATA PRESENT IN BUFFER? — NO →

STORE DATA INDICATED BY READING POINTER OF SOUND CONTENT IN BUFFER
404

YES

TRANSMIT SOUND CORRESPONDING TO ONE FRAME IN BUFFER
406

DOES DATA IN BUFFER END? — NO →
408

YES

UPDATE READING POINTER OF SOUND CONTENT
410

( RETURN )

Europäisches
Patentamt

European
Patent Office

Office européen
des brevets

# EUROPEAN SEARCH REPORT

**Application Number**

EP 16 16 5060

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/029695 A1 (RYCHLIK BOHUSLAV [US]) 31 January 2013 (2013-01-31) * paragraph [0032] * * paragraph [0039]; figure 4 * * paragraph [0075] - paragraph [0077]; figure 11 * ----- | 1-12 | INV. G01C21/36 G06F3/16 G10L25/48 |

TECHNICAL FIELDS SEARCHED (IPC)

G01C
G06F
G10L

The present search report has been drawn up for all claims

| Place of search | Date of completion of the search | Examiner |
|---|---|---|
| The Hague | 27 September 2016 | De Meuleneire, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 16 5060

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2016

| Patent document cited in search report | Publication date | Patent family member(s) | Publication date |
|---|---|---|---|
| US 2013029695 A1 | 31-01-2013 | NONE | |

For more details about this annex : see Official Journal of the European Patent Office, No. 12/82

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004048570 A
- JP 2014228753 A
- JP 2007200298 A
- JP 2014039617 A
- JP 5204323 B
- JP 1036960 A

**Non-patent literature cited in the description**

- **OIKAWA et al.** Optimization of Estimation of Sound Source Direction Using Matching Pursuit. *Journal of Acoustical Society of Japan,* September 2005